# EUROPEAN PATENT APPLICATION

(11) **EP 4 757 558 A1**
(43) Date of publication of application: **10.06.2026**
(21) Application number: 24849538.4
(22) Date of filing: 29.07.2024
(51) Int. Cl.: H10K 59/127, H10K 71/50, H10K 59/121, H10K 59/80, H10K 59/12, G02B 27/01

(54) **DISPLAY DEVICE, MANUFACTURING METHOD THEREOF, AND HEAD-MOUNTED DISPLAY DEVICE INCLUDING DISPLAY DEVICE**

(30) Priority: 31.07.2023 KR 20230100048
(71) Applicant: Samsung Display Co., Ltd., Yongin-si, Gyeonggi-do 17113 (KR)
(72) Inventor: CHOI, Joo Sun, Yongin-si, Gyeonggi-do 17113 (KR)
(74) Representative: Marks & Clerk LLP
(86) International application number: PCT/KR2024/011012
(87) International publication number: WO 2025/028970

(57) **Abstract**

Provided are display device, method of fabricating the same and head mounted display device including the same. The display device comprises a first single crystal semiconductor substrate comprising a plurality of first transistors, a second single crystal semiconductor substrate disposed on the first single crystal semiconductor substrate and comprising a plurality of second transistors, a light emitting element layer disposed on the second single crystal semiconductor substrate and comprising a plurality of light emitting elements, wherein in plan view, an area of the first single crystal semiconductor substrate is smaller than an area of the second single crystal semiconductor substrate, and a minimum line width of one of the plurality of first transistors is smaller than a minimum line of one of the plurality of second transistors.

## Description

### [Technical Field]

The present disclosure relates to a display device, a method of fabricating the same and a head mounted display device including the same.

### [Background of the Invention]

A head mounted display device (HMD) is an image display device that is worn on a user's head in the form of glasses or a helmet to form a focus at a close distance in front of the user's eyes. The head mounted display device may implement virtual reality (VR) or augmented reality (AR).

The head mounted display device magnifies an image displayed on a small display device by using a plurality of lenses, and displays the magnified image. Therefore, the display device applied to the head mounted display device needs to provide high-resolution images, for example, images with a resolution of 3000 PPI (Pixels Per Inch) or higher. To this end, an organic light emitting diode on silicon (OLEDoS), which is a high-resolution small organic light emitting display device, is used as the display device applied to the head mounted display device. The OLEDoS is an image display device in which an organic light emitting diode (OLED) is disposed on a semiconductor wafer substrate on which a complementary metal oxide semiconductor (CMOS) is disposed.

### [Contents of the Invention]

### [Technical Problem]

The problem to be solved by the present disclosure is to provide a micro-display device including a plurality of different single crystal semiconductor substrates, and a head mounted display device having the same.

The problem to be solved by the present disclosure is to provide a method of fabricating a display device, capable of reducing fabricating costs and improving a fabricating yield by performing a semiconductor process of forming devices of different sizes on different wafer substrates.

The tasks of the present invention are not limited to the tasks mentioned above, and other technical tasks not mentioned will be clearly understood by those skilled in the art from the description below.

### [Technical Solutions]

A display device according to one embodiment of the present disclosure for solving the problem includes a first single crystal semiconductor substrate comprising a plurality of first transistors, a second single crystal semiconductor substrate disposed on the first single crystal semiconductor substrate and comprising a plurality of second transistors, a light emitting element layer disposed on the second single crystal semiconductor substrate and comprising a plurality of light emitting elements, wherein in plan view, an area of the first single crystal semiconductor substrate is smaller than an area of the second single crystal semiconductor substrate, and a minimum line width of one of the plurality of first transistors is smaller than a minimum line of one of the plurality of second transistors.

The minimum line width of one of the plurality of first transistors may be less than 100 nm, and the minimum line width of one of the plurality of second transistors may be equal to or greater than 100 nm.

The second single crystal semiconductor substrate may comprise a plurality of through holes spaced apart from each other and a plurality of conductive vias respectively disposed in the plurality of through holes.

The display device may further comprise a connection wiring layer comprising a plurality of connection lines disposed between the first single crystal semiconductor substrate and the light emitting element layer and electrically connected to the plurality of conductive vias, respectively.

The connection wiring layer may be disposed between the first single crystal semiconductor substrate and the second single crystal semiconductor substrate.

The plurality of through holes may not overlap the first single crystal semiconductor substrate in a thickness direction.

Some of the plurality of connection lines may overlap the first single crystal semiconductor substrate in a thickness direction.

Each of the first single crystal semiconductor substrate and the second single crystal semiconductor substrate may be a silicon substrate or a silicon-germanium substrate, and may have a thickness of 100 µm or less.

The light emitting element layer may comprise a plurality of reflective layers disposed between the second single crystal semiconductor substrate and the light emitting element, and an interlayer insulating layer disposed between the reflective layer and the light emitting element, and the plurality of reflective layers may be disposed to correspond to the plurality of light emitting elements, respectively.

The light emitting elements may comprise a first light emitting element disposed in a first emission area emitting light of a first color, and a second light emitting element disposed in a second emission area emitting light of a second color different from the first color, and a thickness of the interlayer insulating layer disposed between the first light emitting element and the reflective layer overlapping the first light emitting element may be different from a thickness of the interlayer insulating layer disposed between the second light emitting element and the reflective layer overlapping the second light emitting element.

A display device according to one embodiment of the present disclosure for solving the problem includes a first single crystal semiconductor substrate comprising a plurality of first transistors, a second single crystal semiconductor substrate disposed on the first single crystal semiconductor substrate, and comprising a plurality of through holes spaced apart from each other and a plurality of conductive vias respectively disposed in the plurality of through holes, a light emitting element layer disposed on the second single crystal semiconductor substrate and comprising a plurality of light emitting elements, and a connection wiring layer comprising connection lines electrically connected to the plurality of conductive vias, respectively, wherein in plan view, an area of the first single crystal semiconductor substrate is smaller than an area of the second single crystal semiconductor substrate.

The second single crystal semiconductor substrate may comprise a plurality of second transistors electrically connected to the plurality of light emitting elements, respectively, and the connection wiring layer may be disposed between the first single crystal semiconductor substrate and the second single crystal semiconductor substrate.

The plurality of through holes may not overlap the first single crystal semiconductor substrate in a thickness direction.

Some of the plurality of connection lines may overlap the first single crystal semiconductor substrate in a thickness direction.

The first single crystal semiconductor substrate may further comprise a plurality of second transistors electrically connected to the plurality of light emitting elements, respectively, and the connection wiring layer may be disposed between the first single crystal semiconductor substrate and the light emitting element layer.

The connection wiring layer may be disposed between the first single crystal semiconductor substrate and the second single crystal semiconductor substrate.

At least some of the plurality of through holes may not overlap the first single crystal semiconductor substrate in a thickness direction.

At least some of the plurality of connection lines may not overlap the first single crystal semiconductor substrate in a thickness direction.

The connection wiring layer may be disposed between the second single crystal semiconductor substrate and the light emitting element layer.

The plurality of through holes may overlap the first single crystal semiconductor substrate in a thickness direction.

A display device according to one embodiment of the present disclosure for solving the problem includes a first single crystal semiconductor substrate comprising a plurality of first transistors, a second single crystal semiconductor substrate disposed on the first single crystal semiconductor substrate, a light emitting element layer disposed on the second single crystal semiconductor substrate and comprising a plurality of light emitting elements, and a passivation layer surrounding the first single crystal semiconductor substrate and in partial contact with the second single crystal semiconductor substrate, wherein in plan view, an area of the first single crystal semiconductor substrate is smaller than an area of the second single crystal semiconductor substrate.

A side surface of the passivation layer may be parallel to a side surface of the second single crystal semiconductor substrate.

A thickness of the passivation layer may be greater than or equal to a thickness of the first single crystal semiconductor substrate.

The passivation layer may be in contact with each of a bottom surface of the first single crystal semiconductor substrate and a bottom surface of the second single crystal semiconductor substrate.

The second single crystal semiconductor substrate may comprise a plurality of through-holes spaced apart from each other, and a plurality of conductive vias respectively disposed in the plurality of through holes, the display device may further comprise a connection wiring layer disposed between the first single crystal semiconductor substrate and the light emitting element layer and comprising a plurality of connection lines electrically connected to the plurality of conductive vias, respectively.

The first single crystal semiconductor substrate may further comprise a plurality of second transistors electrically connected to the light emitting elements, respectively, and at least some of the plurality of connection lines may not overlap the first single crystal semiconductor substrate in a thickness direction.

Each of the plurality of light emitting elements may be electrically connected to one of the plurality of second transistors through the connection lines and the conductive vias.

The second single crystal semiconductor substrate may comprise a plurality of second transistors electrically connected to the light emitting elements, respectively, and a minimum line width of one of the plurality of first transistors may be smaller than a minimum line width of one of the plurality of second transistors.

A method of fabricating a display device according to one embodiment of the present disclosure for solving the problem includes preparing a first wafer substrate and a second wafer substrate different from each other, forming a plurality of first transistors on the first wafer substrate, and forming, in the second wafer substrate, a plurality of through holes penetrating the second wafer substrate and a plurality of conductive vias respectively disposed in the plurality of through holes, dividing the first wafer substrate into a plurality of first single crystal semiconductor substrates, and attaching the first single crystal semiconductor substrates to one surface of the second wafer substrate, forming a planarization layer covering the one surface of the second wafer substrate and the first single crystal semiconductor substrates attached to the one surface, forming a light emitting element layer comprising a plurality of light emitting elements on the other surface opposite to the one surface of the second wafer substrate, and dividing the second wafer substrate into a plurality of second single crystal semiconductor substrates having the light emitting element layer formed on the other surface and the first single crystal semiconductor substrates attached to the one surface.

In plan view, an area of the first single crystal semiconductor substrate may be smaller than an area of the second single crystal semiconductor substrate.

In the forming of the planarization layer, in plan view, an area of the planarization layer may be equal to an area of the second wafer substrate.

In the dividing of the second wafer substrate into the plurality of second single crystal semiconductor substrates, the planarization layer may be divided together with the second single crystal semiconductor substrate to form a passivation layer surrounding the first single crystal semiconductor substrate, and in the display device, a side surface of the passivation layer may be parallel to a side surface of the second single crystal semiconductor substrate.

The method may further comprise before forming the through holes in the second wafer substrate, forming a plurality of second transistors, wherein a minimum line width of one of the first plurality of transistors may be smaller than a minimum line width of one of the plurality of second transistors.

The minimum line width of one of the plurality of first transistors may be less than 100 nm, and the minimum line width of one of the plurality of second transistors may be equal to or greater than 100 nm.

The method may further comprise, before attaching the first single crystal semiconductor substrate to the second wafer substrate, forming a connection wiring layer comprising connection lines electrically connected to the plurality of conductive vias, respectively.

The connection wiring layer may be formed on the one surface of the second single crystal semiconductor substrate, and disposed between the second single crystal semiconductor substrate and the first single crystal semiconductor substrate.

The connection wiring layer may be formed on the other surface of the second single crystal semiconductor substrate, and disposed between the second single crystal semiconductor substrate and the light emitting element layer.

Each of the first single crystal semiconductor substrate and the second single crystal semiconductor substrate may be a silicon substrate or a silicon-germanium substrate, and has a thickness of 100 µm or less.

A head mounted display device according to one embodiment of the present disclosure for solving the problem includes a frame mounted on a user's body and corresponding to left and right eyes, a plurality of display devices disposed on the frame, and lenses respectively disposed on the plurality of display devices, wherein the display device comprises a first single crystal semiconductor substrate comprising a plurality of first transistors, a second single crystal semiconductor substrate disposed on the first single crystal semiconductor substrate, and comprising a plurality of through holes spaced apart from each other and a plurality of conductive vias respectively disposed in the plurality of through holes, and a light emitting element layer disposed on the second single crystal semiconductor substrate and comprising a plurality of light emitting elements, wherein in plan view, an area of the first single crystal semiconductor substrate is smaller than an area of the second single crystal semiconductor substrate.

The display device may further comprise a passivation layer surrounding the first single crystal semiconductor substrate and in partial contact with the second single crystal semiconductor substrate.

The display device may further comprise a connection wiring layer comprising a plurality of connection lines electrically connected to the plurality of conductive vias, respectively.

The second single crystal semiconductor substrate of the display device may comprise a plurality of second transistors electrically connected to the plurality of light emitting elements, respectively, and
the connection wiring layer may be disposed between the first single crystal semiconductor substrate and the second single crystal semiconductor substrate.

In the display device, a minimum line width of one of the plurality of first transistors may be smaller than a minimum line width of one of the plurality of second transistors.

The minimum line width of the first transistor may be less than 100 nm, and the minimum line width of the second transistor may be equal to or greater than 100 nm.

The first single crystal semiconductor substrate of the display device may comprise a plurality of second transistors electrically connected to the plurality of light emitting elements, respectively, and the connection wiring layer may be disposed between the first single crystal semiconductor substrate and the light emitting element layer.

The connection wiring layer may be disposed between the first single crystal semiconductor substrate and the second single crystal semiconductor substrate, and at least some of the plurality of through holes may not overlap the first single crystal semiconductor substrate in a thickness direction.

The connection wiring layer may be disposed between the second single crystal semiconductor substrate and the light emitting element layer, and the plurality of through holes may overlap the first single crystal semiconductor substrate in a thickness direction.

Each of the first single crystal semiconductor substrate and the second single crystal semiconductor substrate may be a silicon substrate or a silicon-germanium substrate, and may have a thickness of 100 µm or less.

Specific details of other embodiments are included in the detailed description and drawings.

### [Effects of the Invention]

A display device according to one embodiment may include two different single crystal semiconductor substrates. In this display device, in plan view, the area of the single crystal semiconductor substrate disposed on the lower side may be smaller than the area of the single crystal semiconductor substrate disposed on the upper side.

Accordingly, in the fabricating process of the single crystal semiconductor substrate disposed on the lower side, a large number of semiconductor substrates per unit wafer substrate can be fabricated, so that the fabricating yield may be improved. In addition, the fabricating process of the single crystal semiconductor substrate disposed on the upper side has advantages in that unnecessary regions per unit area can be minimized and a high-resolution display device per unit area can be implemented.

The effects according to the embodiments are not limited to the contents exampled above, and more diverse effects are included in the present disclosure.

### [Brief Description of the Drawings]

FIG. 1 is an exploded perspective view of a display device according to one embodiment.
FIG. 2 is a plan view illustrating an example of the driving part shown in FIG. 1.
FIG. 3 is a plan view illustrating an example of the display part shown in FIG. 1.
FIG. 4 is a block diagram illustrating a display device according to one embodiment.
FIG. 5 is an equivalent circuit diagram of a sub-pixel according to one embodiment.
FIG. 6 is a schematic cross-sectional view of a display device according to one embodiment.
FIG. 7 is a schematic cross-sectional view of a driving part according to one embodiment.
FIG. 8 is a plan view illustrating the layout of pixels disposed in a display area of a display part according to one embodiment.
FIG. 9 is a cross-sectional view taken along line A-A' of FIG. 8.
FIGS. 10 and 11 are plan views illustrating the layout of a display area of a display part according to another embodiment.
FIG. 12 is a flowchart illustrating a fabricating process of a display device according to one embodiment.
FIGS. 13 to 18 are views sequentially illustrating a fabricating process of a display device according to one embodiment.
FIG. 19 is a schematic cross-sectional view of a display device according to another embodiment.
FIG. 20 is a plan view illustrating an example of a display part of the display device of FIG. 19.
FIG. 21 is a schematic cross-sectional view of a display device according to another embodiment.
FIG. 22 is a plan view illustrating an example of a driving part of the display device of FIG. 21.
FIG. 23 is a plan view illustrating an example of a display part of the display device of FIG. 21.
FIG. 24 is a cross-sectional view showing a part of the driving part of FIG. 22.
FIG. 25 is a cross-sectional view showing a part of the display part of FIG. 23.
FIG. 26 is a cross-sectional view schematically illustrating transistors of a driving part and a display part of the display device of FIG. 21.
FIG. 27 is a perspective view illustrating a head mounted display device according to one embodiment.
FIG. 28 is an exploded perspective view showing an example of the head mounted display device of FIG. 27.
FIG. 29 is a perspective view illustrating a head mounted display device according to one embodiment.

### [Detailed Description of the Preferred Embodiments]

The advantages and features of the present invention, as well as the methods for achieving them, will become clearer with reference to the embodiments described below in detail with the accompanying drawings. However, the present invention is not limited to the embodiments disclosed below and may be implemented in various forms. These embodiments are provided solely to ensure the complete disclosure of the present invention and to fully convey the scope of the invention to those skilled in the art. The present invention is defined solely by the scope of the claims.

When an element or layer is referred to as "on" another element or layer, it includes both cases where the other layer or element is directly above the other element or intervening therewith. Similarly, when referred to as "below," "left," and "right," it includes cases where the other element is directly adjacent to the other element or intervening therewith with another layer or material. Like reference numerals refer to like elements throughout the specification.

Although the terms "first," "second," etc. are used to describe various elements, these elements are not limited by these terms. These terms are used solely to distinguish one component from another. Therefore, it should be understood that the first component referred to below may also be a second component within the technical scope of the present invention.

Hereinafter, embodiments will be described with reference to the attached drawings.

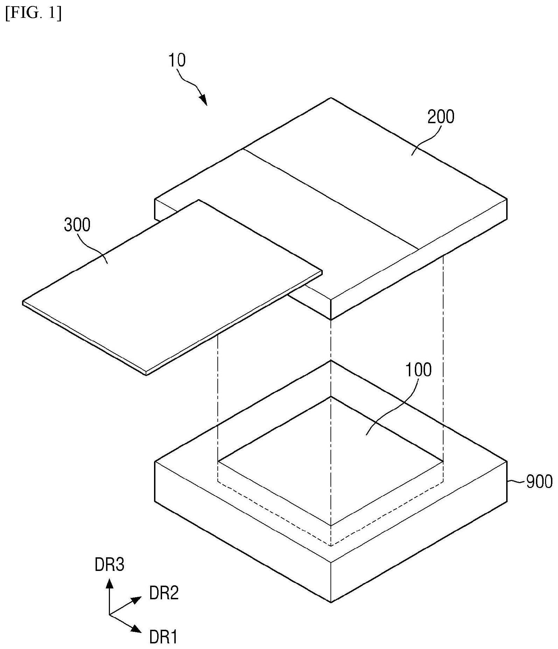

FIG. 1 is an exploded perspective view of a display device according to one embodiment.

Referring to FIG. 1, a display device 10 according to one embodiment is a device displaying a moving image or a still image. The display device 10 according to one embodiment may be applied to portable electronic devices such as a mobile phone, a smartphone, a tablet personal computer, a mobile communication terminal, an electronic organizer, an electronic book, a portable multimedia player (PMP), a navigation system, an ultra mobile PC (UMPC) or the like. For example, the display device 10 may be applied as a display part of a television, a laptop, a monitor, a billboard, or an Internet-of-Things (IoT) device. Alternatively, the display device 10 may be applied to a smart watch, a watch phone, a head mounted display device (HMD) for implementing virtual reality and augmented reality, and the like.

The display device 10 according to one embodiment may include a driving part 100, a display part 200, and a circuit board 300. The display device 10 may further include a passivation layer 900 disposed around the driving part 100.

The driving part 100 may have a planar shape similar to a quadrilateral shape. For example, the driving part 100 may have a planar shape similar to a square, having one side of a first direction DR1 and the other side of a second direction DR2 crossing the first direction DR1. In the driving part 100, a corner where one side in the first direction DR1 and the other side in the second direction DR2 meet may be right-angled or rounded with a predetermined curvature. The planar shape of the driving part 100 is not limited to a rectangular shape, and may be a shape similar to another polygonal shape, a circular shape, or an elliptical shape. The planar shape of the display device 10 may conform to the planar shape of the driving part 100, but is not limited thereto.

The display part 200 may be disposed on the driving part 100. In FIG. 1, the display part 200 and the driving part 100 are illustrated as being spaced apart from each other, but this is only an example where they are separated for the purpose of illustrating the driving part 100. In the display device 10, the driving part 100 and the display part 200 may be bonded to each other. The display part 200 may have a shape substantially similar to that of the driving part 100. For example, the driving part 100 may have a planar shape similar to a square, having one side of the first direction DR1 and the other side of the second direction DR2 crossing the first direction DR1. The planar shape of the display part 200 is not limited to a rectangular shape, and may be a shape similar to another polygonal shape, a circular shape, or an elliptical shape.

According to one embodiment, in the display device 10, the area of the display part 200 in plan view may be larger than the area of the driving part 100 in plan view. The display device 10 may include the driving part 100 and the display part 200 having different substrates, and they may have different areas. Elements formed in the driving part 100 and elements formed in the display part 200 may be different, and these elements may be formed individually on different substrates. The display device 10 may be fabricated by forming multiple elements with different sizes, line widths, and fabricating processes on different substrates and then bonding them. This display device 10 may have advantages in that product performance and fabricating yield can be improved. A description thereof will be given later with reference to other drawings.

The circuit board 300 may be electrically connected to a plurality of pads in a pad area of the display part 200 by using a conductive adhesive member such as an anisotropic conductive film. The circuit board 300 may be a flexible printed circuit board with a flexible material, or a flexible film. Although the circuit board 300 is illustrated in FIG. 1 as being unfolded, the circuit board 300 may be bent. In this case, one end of the circuit board 300 may be disposed on the bottom surface of the driving part 100. The other end of the circuit board 300 may be connected to the plurality of pads in the pad area of the display part 200 by using the conductive adhesive member.

Although not shown in FIG. 1, the display device 10 may further include a heat dissipation layer overlapping the driving part 100 and the display part 200 in a third direction DR3. The heat dissipation layer may be disposed on the bottom surface of the driving part 100, and may dissipate heat generated from the driving part 100 and the display part 200. The heat dissipation layer may include a metal layer such as graphite, silver (Ag), copper (Cu), or aluminium (Al) having high thermal conductivity.

The passivation layer 900 may be disposed on the bottom surface of the display part 200, surrounding the driving part 100. The passivation layer 900 may reduce a step due to the difference in the area between the driving part 100 and the display part 200, and may also protect the driving part 100 and the display part 200.

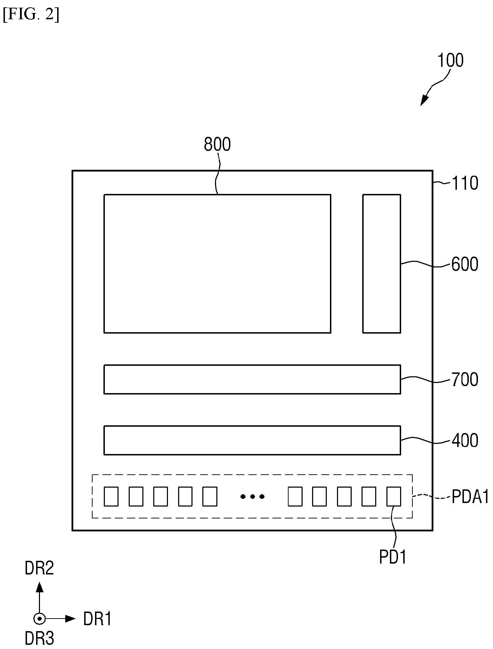

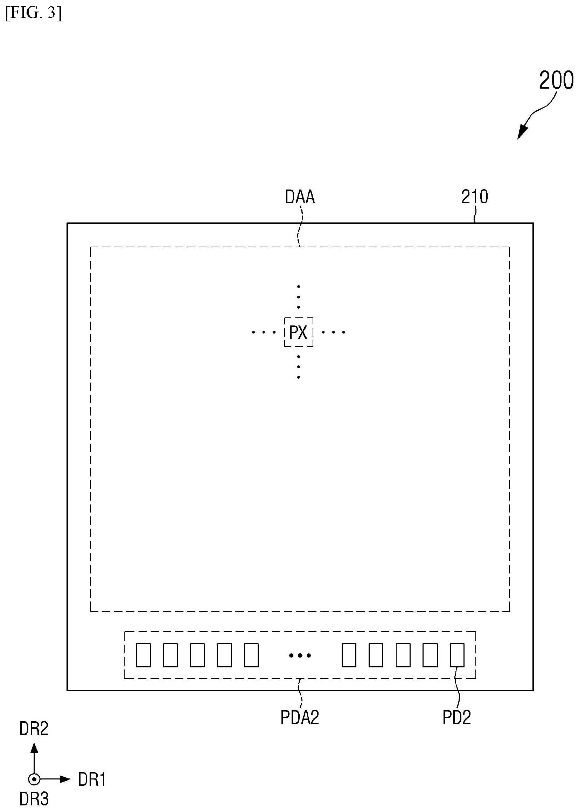

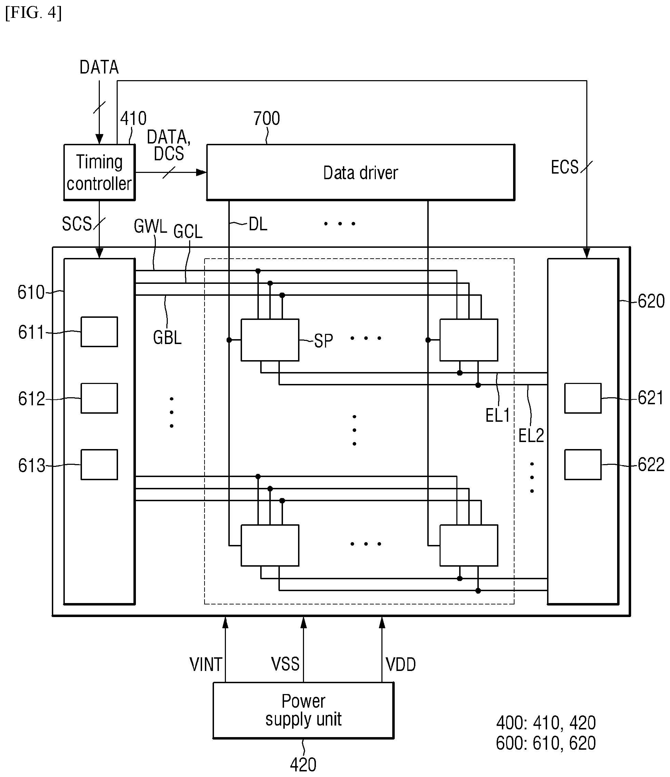

FIG. 2 is a plan view illustrating an example of the driving part shown in FIG. 1. FIG. 3 is a plan view illustrating an example of the display part shown in FIG. 1. FIG. 4 is a block diagram illustrating a display device according to one embodiment.

Referring to FIGS. 2 to 4, the driving part 100 of the display device 10 may include driving circuit elements of the display device 10. The driving part 100 may include a first single crystal semiconductor substrate 110, and a driving circuit part 400, a gate driver 600, a data driver 700, and a pixel circuit part 800 formed on the first single crystal semiconductor substrate 110.

The first single crystal semiconductor substrate 110 may be a silicon substrate, a germanium substrate, or a silicon-germanium substrate. The first single crystal semiconductor substrate 110 may comprise transistors of the driving circuit elements. The first single crystal semiconductor substrate 110 may comprise at least one part of each of the transistors of the driving circuit elements. For example, the transistors of the driving circuit elements may be formed partly within and partly on the first single crystal semiconductor substrate 110. The plurality of transistors may be electrically connected to each other to form the driving circuit part 400, the gate driver 600, the data driver 700, and the pixel circuit part 800.

It is illustrated in FIG. 2 that the pixel circuit part 800 is disposed on the upper side of the driving part 100, the gate driver 600 is disposed on the right thereof, and the data driver 700 and the driving circuit part 400 are disposed under the pixel circuit part 800. However, the disclosure is not limited thereto. The positions of the driving circuit part 400, the gate driver 600, the data driver 700, and the pixel circuit part 800 may be changed in various ways according to the design structure of multiple circuit elements included on the first single crystal semiconductor substrate 110.

The driving circuit part 400 may include a timing control circuit 410 and a power supply circuit 420. In addition, the driving circuit part 400 may further include various circuits involved in driving the display device 10, such as a gamma circuit and a logic circuit. The driving circuit part 400 may include the plurality of transistors included on the first single crystal semiconductor substrate 110.

The transistors may be formed through a semiconductor process. For example, the plurality of transistors may be formed as complementary metal oxide semiconductor (CMOS) transistors.

The timing control circuit 410 may receive digital video data and timing signals inputted from the outside. The timing control circuit 410 may generate a scan timing control signal SCS, an emission timing control signal ECS, and a data timing control signal DCS for controlling the display part 200 according to the timing signals. The timing control circuit 410 may output the scan timing control signal SCS to a scan driver 610 of the gate driver 600, and may output the emission timing control signal ECS to an emission driver 620 of the gate driver 600. The timing control circuit 410 may output the digital video data and the data timing control signal DCS to the data driver 700.

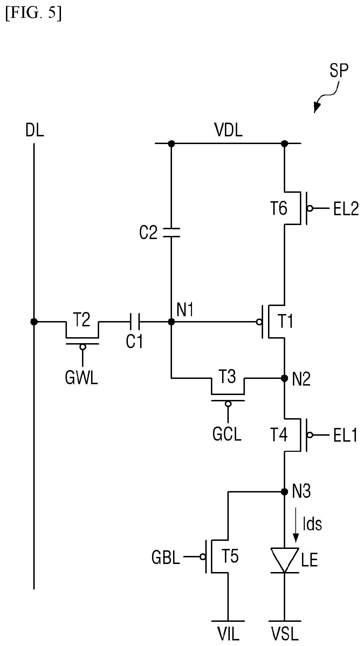

The power supply circuit 420 may generate a plurality of panel driving voltages according to a power voltage from the outside. For example, the power supply circuit 420 may generate a first driving voltage VSS, a second driving voltage VDD, and a third driving voltage VINT and supply them to the pixel circuit part 800. Description of the first driving voltage VSS, the second driving voltage VDD, and the third driving voltage VINT will be provided later with reference to FIG. 5.

The scan timing control signal SCS, the emission timing control signal ECS, digital video data DATA, and the data timing control signal DCS of the timing control circuit 410 may be supplied to the pixel circuit part 800. The first driving voltage VSS, the second driving voltage VDD, and the third driving voltage VINT of the power supply circuit 420 may also be supplied to the pixel circuit part 800. The driving part 100 may be bonded to the bottom surface of the display part 200, and the driving circuit part 400 of the driving part 100 may be electrically connected to the display part 200.

The gate driver 600 may include the scan driver 610 and the emission driver 620. The scan driver 610 includes a plurality of scan transistors formed on the first single crystal semiconductor substrate 110, and the emission driver 620 includes a plurality of emission transistors formed on the first single crystal semiconductor substrate 110. For example, at least a part of each of the plurality of scan transistors of the scan circuit unit 610 may be included in the first single-crystal semiconductor substrate 110. In this case, a part of each of the plurality of scan transistors of the scan circuit unit 610 may be formed within the first single-crystal semiconductor substrate 110, and the remaining part of each of the plurality of scan transistors may be formed on the first single-crystal semiconductor substrate 110. In addition, at least a part of each of the plurality of light-emitting transistors of the light-emitting driver unit 620 may be included in the first single-crystal semiconductor substrate 110. In this case, a part of each of the plurality of light-emitting transistors of the light-emitting circuit unit 620 may be formed within the first single-crystal semiconductor substrate 110, and the remaining part of each of the plurality of light-emitting transistors may be formed on the first single-crystal semiconductor substrate 110.

The plurality of scan transistors and the plurality of emission transistors may be formed through a semiconductor process. For example, the plurality of scan transistors and the plurality of emission transistors may be formed as CMOS transistors.

The scan driver 610 may include a write scan signal output part 611, a control scan signal output part 612, and a bias scan signal output part 613. Each of the write scan signal output part 611, the control scan signal output part 612, and the bias scan signal output part 613 may receive the scan timing control signal SCS from the timing control circuit 410. The write scan signal output part 611 may generate write scan signals according to the scan timing control signal SCS of the timing control circuit 410 and output them sequentially to write scan lines GWL. The control scan signal output part 612 may generate control scan signals according to the scan timing control signal SCS and output them sequentially to write control lines GCL. The bias scan signal output part 613 may generate bias scan signals according to the scan timing control signal SCS and output them sequentially to bias scan lines GBL.

The emission driver 620 includes a first emission control driver 621 and a second emission control driver 622. Each of the first emission control driver 621 and the second emission control driver 622 may receive the emission timing control signal ECS from the timing control circuit 410. The first emission control driver 621 may generate first emission control signals according to the emission timing control signal ECS and sequentially output them to first emission control lines EL1. The second emission control driver 622 may generate second emission control signals according to the emission timing control signal ECS and sequentially output them to second emission control lines EL2.

The data driver 700 includes a plurality of data transistors included in the first single crystal semiconductor substrate 110. For example, at least a part of each of the plurality of data transistors of the data driving unit 700 may be included in the first single-crystal semiconductor substrate 110. In this case, a part of each of the plurality of data transistors of the data driving unit 700 may be formed within the first single-crystal semiconductor substrate 110, and the remaining part of each of the plurality of data transistors may be formed on the first single-crystal semiconductor substrate 110.

The plurality of data transistors may be formed through a semiconductor process. For example, the plurality of data transistors may be formed as CMOS transistors. The data driver 700 may receive the digital video data DATA and the data timing control signal DCS from the timing control circuit 410. The data driver 700 converts the digital video data DATA into analog data voltages according to the data timing control signal DCS and outputs the analog data voltages to data lines DL. In this case, sub-pixels SP are selected by the write scan signal of the scan driver 610, and the data voltages may be supplied to the selected sub-pixels SP.

A first pad area PDA1 may include a plurality of first pads PD1 arranged in the first direction DR1. The plurality of first pads PD1 may be electrically connected to a plurality of second pads PD2 of the display part 200, and may be electrically connected to the circuit board 300 through these second pads PD2. The first pads PD1 may transmit an electrical signal applied from the circuit board 300 to the driving circuit part 400, the gate driver 600, the data driver 700, and the pixel circuit part 800.

The pixel circuit part 800 includes a plurality of pixel transistors included in the first single crystal semiconductor substrate 110. For example, at least a part of each of the plurality of pixel transistors of the pixel circuit unit 800 may be included in the first single-crystal semiconductor substrate 110. In this case, a part of each of the plurality of pixel transistors of the pixel circuit unit 800 may be formed within the first single-crystal semiconductor substrate 110, and the remaining part of each of the plurality of pixel transistors may be formed on the first single-crystal semiconductor substrate 110.

The plurality of pixel transistors may be formed through a semiconductor process. For example, the plurality of pixel transistors may be formed as CMOS transistors.

The plurality of data lines DL, a plurality of scan lines SL, and a plurality of emission control lines EL may be disposed in the pixel circuit part 800. The plurality of scan lines SL and the plurality of emission control lines EL may extend in the first direction DR1, while being arranged in the second direction DR2. The plurality of data lines DL may extend in the second direction DR2, while being arranged in the first direction DR1.

The plurality of scan lines SL include the plurality of write scan lines GWL, the plurality of write control lines GCL, and the plurality of bias scan lines GBL. The plurality of emission control lines EL include the plurality of first emission control lines EL1 and the plurality of second emission control lines EL2. The plurality of scan lines SL, the plurality of emission control lines EL, and the plurality of data lines DL may be electrically connected to the plurality of pixel transistors, and the pixel circuit part 800 may be electrically connected to pixels PX of the display part 200 to transmit an electrical signal necessary for emission of a light emitting element.

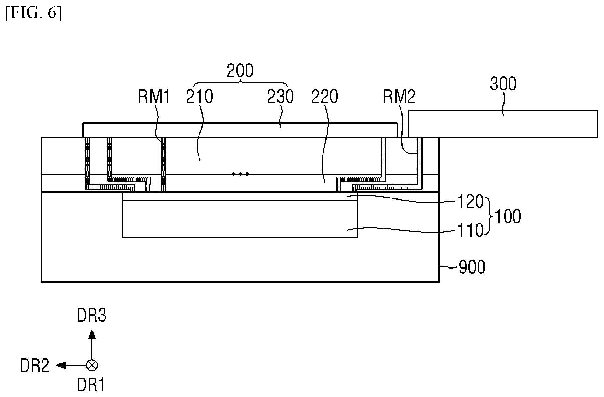

The display part 200 may include a display area DAA in which light emitting elements emitting light are disposed to display an image. The display part 200 may include a second single crystal semiconductor substrate 210 and a display element layer 230 (see FIG. 6) disposed on the second single crystal semiconductor substrate 210.

The second single crystal semiconductor substrate 210 may be a silicon substrate, a germanium substrate, or a silicon-germanium substrate. Transistor elements may not be formed on the second single crystal semiconductor substrate 210. However, the disclosure is not limited thereto. In another embodiment, the second single crystal semiconductor substrate 210 may also include circuit elements necessary for driving the display device 10.

The plurality of pixels PX including light emitting elements may be disposed in the display area DAA. The plurality of pixels PX may be arranged in a matrix form in the first direction DR1 and the second direction DR2. Each of the plurality of pixels PX may include the plurality of sub-pixels SP, and the sub-pixels SP may be electrically connected to the pixel circuit part 800 of the driving part 100. Each of the sub-pixels SP includes light emitting elements, and each light emitting element may emit light according to an electrical signal applied from the pixel circuit part 800. Some of the pixels PX disposed in the display area DAA of the display part 200 may overlap the pixel circuit part 800 of the driving part 100 in the thickness direction. However, they are disposed on the separate single crystal semiconductor substrates 110 and 210, and they may be electrically connected to each other through a connection wiring layer 220 (see FIG. 6) disposed between them.

Each of the plurality of sub-pixels SP may be connected to any one of the plurality of write scan lines GWL, any one of the plurality of write control lines GCL, any one of the plurality of bias scan lines GBL, any one of the plurality of first emission control lines EL1, any one of the plurality of second emission control lines EL2, and any one of the plurality of data lines DL of the pixel circuit part 800. Each of the plurality of sub-pixels SP may receive the data voltage of the data line DL according to the write scan signal of the write scan line GWL, and may emit light from a light emitting element thereof according to the data voltage.

A second pad area PDA2 may include a plurality of second pads PD2 disposed in the first direction DR1. The plurality of second pads PD2 may be electrically connected to the plurality of first pads PD1 of the driving part 100, and the circuit board 300 may be attached thereon. The second pads PD2 may be electrically connected to the circuit board 300, and may serve to transmit the electrical signal applied from the circuit board 300 to the driving part 100.

FIG. 5 is an equivalent circuit diagram of a sub-pixel according to one embodiment.

Referring to FIG. 5, the sub-pixel SP may be connected to the write scan line GWL, the write control line GCL, the bias scan line GBL, the first emission control line EL1, the second emission control line EL2, and the data line DL. In addition, the sub-pixel SP may be connected to a first driving voltage line VSL to which the first driving voltage VSS corresponding to a low potential voltage is applied, a second driving voltage line VDL to which the second driving voltage VDD corresponding to a high potential voltage is applied, and a third driving voltage line VIL to which the third driving voltage VINT corresponding to an initialization voltage is applied. That is, the first driving voltage line VSL may be a low potential voltage line, the second driving voltage line VDL may be a high potential voltage line, and the third driving voltage line VIL may be an initialization voltage line. In this case, the first driving voltage VSS may be lower than the third driving voltage VINT. The second driving voltage VDD may be higher than the third driving voltage VINT.

The sub-pixel SP includes a plurality of transistors T1 to T6, a light emitting element LE, a first capacitor C1, and a second capacitor C2.

The light emitting element LE emits light according to a drain-source current Ids (hereinafter referred to as a driving current) flowing through the channel of the first transistor T1. The emission amount of the light emitting element LE may be proportional to the driving current Ids. The light emitting element LE may be disposed between the fourth transistor T4 and the first driving voltage line VSL. The first electrode of the light emitting element LE may be connected to the drain electrode of the fourth transistor T4, and the second electrode thereof may be connected to the first driving voltage line VSL. The first electrode of the light emitting element LE may be an anode electrode, and the second electrode of the light emitting element LE may be a cathode electrode. The light emitting element LE may be an organic light emitting diode including a first electrode, a second electrode, and an organic light emitting layer disposed between the first electrode and the second electrode, but is not limited thereto. For example, the light emitting element LE may be an inorganic light emitting element including a first electrode, a second electrode, and an inorganic semiconductor disposed between the first electrode and the second electrode, in which case the light emitting element LE may be a micro light emitting diode.

The first transistor T1 may be a driving transistor that controls the driving current Ids flowing between the source electrode and the drain electrode thereof according to a voltage applied to the gate electrode thereof. The first transistor T1 includes a gate electrode connected to the first node N1, a source electrode connected to the drain electrode of the sixth transistor T6, and a drain electrode connected to a second node N2.

The second transistor T2 may be disposed between one electrode of the first capacitor C1 and the data line DL. The second transistor T2 is turned on by the write scan signal of the write scan line GWL to connect the one electrode of the first capacitor C1 to the data line DL. Accordingly, the data voltage of the data line DL may be applied to the one electrode of the first capacitor C1. The second transistor ST2 includes a gate electrode connected to the write scan line GWL, a source electrode connected to the data line DL, and a drain electrode connected to the one electrode of the first capacitor C1.

The third transistor T3 may be disposed between the first node N1 and the second node N2. The third transistor T3 is turned on by the write control signal of the write control line GCL to connect the first node N1 to the second node N2. For this reason, since the gate electrode and the source electrode of the first transistor T1 are connected, the first transistor T1 may operate like a diode. The third transistor T3 includes a gate electrode connected to the write control line GCL, a source electrode connected to the second node N2, and a drain electrode connected to the first node N1.

The fourth transistor T4 may be connected between the second node N2 and a third node N3. The fourth transistor ST4 is turned on by the first emission control signal of the first emission control line EL1 to connect the second node N2 to the third node N3. Accordingly, the driving current of the first transistor T1 may be supplied to the light emitting element LE. The fourth transistor T4 includes a gate electrode connected to the first emission control line EL1, a source electrode connected to the second node N2, and a drain electrode connected to the third node N3.

The fifth transistor T5 may be disposed between the third node N3 and the third driving voltage line VIL. The fifth transistor T5 is turned on by the bias scan signal of the bias scan line GBL to connect the third node N3 to the third driving voltage line VIL. Accordingly, the third driving voltage VINT of the third driving voltage line VIL may be applied to the first electrode of the light emitting element LE. The fifth transistor T5 includes a gate electrode connected to the bias scan line GBL, a source electrode connected to the third node N3, and a drain electrode connected to the third driving voltage line VIL.

The sixth transistor T6 may be disposed between the source electrode of the first transistor T1 and the second driving voltage line VDL. The sixth transistor T6 is turned on by the second emission control signal of the second emission control line EL2 to connect the source electrode of the first transistor T1 to the second driving voltage line VDL. Accordingly, the second driving voltage VDD of the second driving voltage line VDL may be applied to the source electrode of the first transistor T1. The sixth transistor T6 includes a gate electrode connected to the second emission control line EL2, a source electrode connected to the second driving voltage line VDL, and a drain electrode connected to the source electrode of the first transistor T1.

The first capacitor C1 is formed between the first node N1 and the drain electrode of the second transistor T2. The first capacitor C1 includes one electrode connected to the drain electrode of the second transistor T2 and the other electrode connected to the first node N1.

The second capacitor C2 is formed between the gate electrode of the first transistor T1 and the second driving voltage line VDL. The second capacitor C2 includes one electrode connected to the gate electrode of the first transistor T1 and the other electrode connected to the second driving voltage line VDL.

The first node N1 is a junction between the gate electrode of the first transistor T1, the drain electrode of the third transistor T3, the other electrode of the first capacitor C1, and the one electrode of the second capacitor C2. The second node N2 is a junction between the drain electrode of the first transistor T1, the source electrode of the third transistor T3, and the source electrode of the fourth transistor T4. The third node N3 is a junction between the drain electrode of the fourth transistor T4, the source electrode of the fifth transistor T5, and the first electrode of the light emitting element LE.

Each of the first to sixth transistors T1 to T6 may be a metal-oxide-semiconductor field effect transistor (MOSFET). For example, each of the first to sixth transistors T1 to T6 may be a P-type MOSFET, but is not limited thereto. Each of the first to sixth transistors T1 to T6 may be an N-type MOSFET. Alternatively, some of the first to sixth transistors T1 to T6 may be P-type MOSFETs, and each of the remaining transistors may be an N-type MOSFET.

Although FIG. 5 illustrates that the sub-pixel SP includes the six transistors T1 to T6 and the two capacitors C1 and C2, it should be noted that the equivalent circuit diagram of the sub-pixel SP is not limited to that shown in FIG. 5. For example, the number of the transistors and the number of the capacitors of the sub-pixel SP are not limited to the example shown in FIG. 5.

FIG. 6 is a schematic cross-sectional view of a display device according to one embodiment.

Referring to FIG. 6, the display device 10 according to one embodiment may include the driving part 100 including the first single crystal semiconductor substrate 110 and a driving circuit layer 120 disposed on the first single crystal semiconductor substrate 110; and the display part 200 including the second single crystal semiconductor substrate 210 and the display element layer 230 disposed on the second single crystal semiconductor substrate 210. The display device 10 may include the two different single crystal semiconductor substrates 110 and 210 overlapping each other in the third direction DR3, which is the thickness direction of the display device 10.

The driving part 100 may include circuit elements necessary for emission of light emitting elements included in the display element layer 230 of the display part 200. As described above, the driving circuit layer 120 of the driving part 100 may include the driving circuit part 400, the gate driver 600, the data driver 700, and so forth, and the circuit elements constituting them, such as transistors and capacitors, may be formed of CMOS on the first single crystal semiconductor substrate 110. The display part 200 may include a plurality of light emitting elements that emit light to display an image of the display device 10. The light emitting elements may be electrically connected to the circuit elements formed in the driving part 100 to emit light.

In the display device 10, the light emitting elements and the circuit elements may be formed on two different substrates, respectively, to efficiently utilize the space of each substrate. For example, the display element layer 230 and the second pads PD2 may be disposed on the second single crystal semiconductor substrate 210 of the display part 200, and the circuit elements electrically connected to them may be disposed on the first single crystal semiconductor substrate 110 of the driving part 100. Since the second single crystal semiconductor substrate 210 does not need to have a space for accommodating therein the circuit elements, unnecessary areas other than the display area DAA, in which light emitting elements are not disposed, may be minimized.

According to one embodiment, in the display device 10, in plan view, the area of the driving part 100 or the first single crystal semiconductor substrate 110 may be smaller than the area of the display part 200 or the second single crystal semiconductor substrate 210. A plurality of transistors formed in the driving part 100 may be formed through a semiconductor micro-process, and thus may have a very small size or line width. The driving part 100 has advantages in that a large number of circuit elements may be disposed with a high degree of integration, and power consumption may be reduced due to the miniaturization of the size of the elements.

In addition, since the driving part 100 includes only the circuit elements formed of CMOS on the first single crystal semiconductor substrate 110 and does not include light emitting elements, the driving part 100 only needs to secure a space for accommodating the elements formed by the micro-process therein. Since it still works even if the first single crystal semiconductor substrate 110 has a smaller area than the second single crystal semiconductor substrate 210, a large number of driving parts 100 may be fabricated on a single wafer substrate on which the process of forming the driving circuit layer 120 is performed, so that the fabricating yield may be improved. In particular, since a high-cost semiconductor process is performed to fabricate the driving part 100, such improvement in the fabricating yield of the driving part 100 may lead to cost reduction. Further, in the display part 200, since a large number of light emitting elements can be formed on the second single crystal semiconductor substrate 210 having a relatively large area, a high-resolution display device may be implemented.

According to one embodiment, the display device 10 may include the connection wiring layer 220 disposed between the second single crystal semiconductor substrate 210 of the display part 200 and the driving circuit layer 120 of the driving part 100. The connection wiring layer 220 may be disposed on the bottom surface of the second single crystal semiconductor substrate 210. The connection wiring layer 220 may include a plurality of routing lines RM1 and RM2, and these routing lines RM1 and RM2 may connect the circuit board 300 and the light emitting elements of the display element layer 230 disposed on the display part 200 to the driving part 100. The driving circuit layer 120 of the driving part 100 may be electrically connected to the display part 200 and the circuit board 300 through the routing lines RM1 and RM2 of the connection wiring layer 220 to transmit an electrical signal for light emission.

The first routing line RM1 may be connected to the display element layer 230 disposed in the display part 200. The first routing line RM1 may be electrically connected to the light emitting element of the display element layer 230 and the pixel circuit part 800 of the driving part 100. The second routing line RM2 may be connected to the circuit board 300. The second routing line RM2 may be electrically connected to the first pad PD1 of the driving part 100 and the second pad PD2 of the display part 200. The first routing line RM1 may be a wire that transmits a circuit signal necessary for emission of the light emitting elements included in the display element layer 230. The second routing line RM2 may be a wire that transmits a signal applied from the circuit board 300 to the driving part 100.

According to one embodiment, the display part 200 of the display device 10 includes multiple through holes formed in the second single crystal semiconductor substrate 210, and the routing lines RM1 and RM2 of the connection wiring layer 220 may be electrically connected to the light emitting element layer 230 through the through holes of the second single crystal semiconductor substrate 210, respectively. The second single crystal semiconductor substrate 210 may be disposed between the display element layer 230 and the driving circuit layer 120 and may include one or more through holes to provide a path for electrical connection of the routing lines RM1 and RM2.

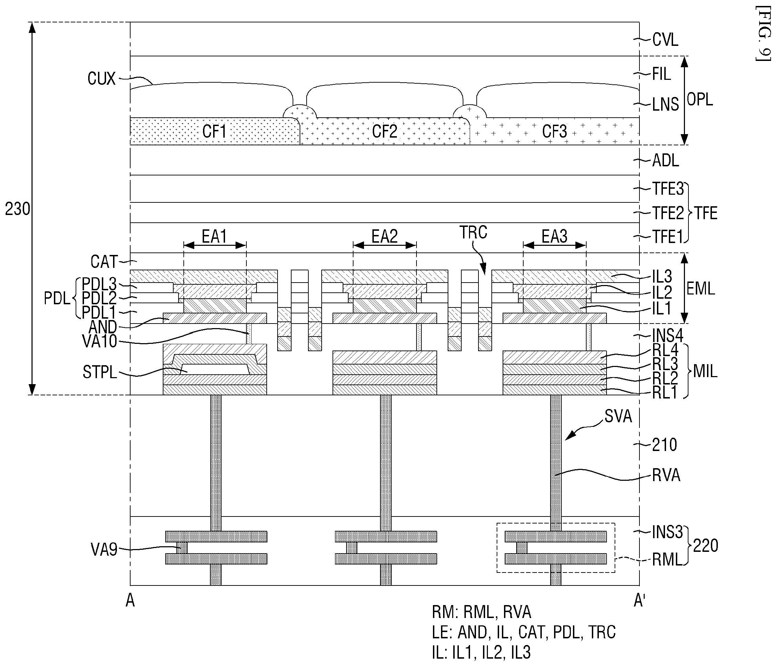

The routing lines RM1 and RM2 may include connection lines RML (see FIG. 9) disposed in the connection wiring layer 220 and conductive vias disposed in the through holes of the second single crystal semiconductor substrate 210. The routing lines RM1 and RM2 are configured to electrically connect the layers disposed above and below the second single crystal semiconductor substrate 210, and the layout and the design of the through holes formed in the second single crystal semiconductor substrate 210 may vary depending on the layout of the layers electrically connected to the routing lines RM1 and RM2.

For example, in the embodiment of FIG. 6, the first routing line RM1 may connect each of the light emitting elements disposed in the plurality of pixels PX of the display element layer 230 to the pixel circuit part 800 of the driving part 100. Since the area of the second single crystal semiconductor substrate 210 in plan view is larger than that of the first single crystal semiconductor substrate 110, some of the pixels PX included in the display element layer 230 of the display part 200 may overlap the pixel circuit part 800 in the thickness direction, while some others of the pixels PX may not overlap the pixel circuit part 800 in the thickness direction.

The conductive vias of the first routing line RM1 are arranged to overlap the pixel circuit part 800 in the thickness direction, and among the plurality of through holes formed in the second single crystal semiconductor substrate 210, the through holes in which the first routing line RM1 is disposed may also overlap the pixel circuit part 800 in the thickness direction. The connection lines of the first routing line RM1 may be formed across the entire surface of the second single crystal semiconductor substrate 210 while being electrically connected to the pixels PX of the display element layer 230, respectively, and the conductive vias of the first routing line RM1 may be concentrated in a region overlapping the pixel circuit part 800.

Meanwhile, the conductive vias of the second routing line RM2 may be arranged to overlap the first pad PD1 of the driving part 100, and among the plurality of through holes formed in the second single crystal semiconductor substrate 210, the through holes in which the second routing line RM2 is disposed may also overlap the first pad PD1 in the thickness direction. The connection lines of the second routing line RM2 may be electrically connected to the second pad PD2 of the display part 200 to form a path for electrical connection to the conductive vias connected to the first pad PD1. However, the disclosure is not limited thereto. The layout and the connection design of the connection lines of the first and second routing lines RM1 and RM2 may be modified in various ways.

The passivation layer 900 may be disposed around the driving part 100. The passivation layer 900 may be disposed on the bottom surface of the display part 200 while surrounding the driving part 100. The passivation layer 900 may be formed to cover the driving part 100 in the fabricating process of the display device 10 to fill the step between the driving part 100 and the display part 200. In the fabricating process of the display device 10, when the first single crystal semiconductor substrate 110 is attached to the bottom surface of the second single crystal semiconductor substrate 210 whose area is different from that of the first single crystal semiconductor substrate 110, the passivation layer 900 may fill the step between the first single crystal semiconductor substrate 110 and the second single crystal semiconductor substrate 210, and an additional process may be performed on the second single crystal semiconductor substrate 210.

In one embodiment, the thickness of the passivation layer 900 may be larger than the thickness of the first single crystal semiconductor substrate 110. The passivation layer 900 may be thicker than or equal to the sum of the thicknesses of the first single crystal semiconductor substrate 110 of the driving part 100 and the driving circuit layer 120 disposed thereon. The passivation layer 900 may be formed to be thicker than the driving part 100, so a part of the passivation layer 900 may be in direct contact with the bottom surface of the display part 200, while another part thereof may be in direct contact with the bottom surface of the driving part 100. Accordingly, the driving part 100 and the display part 200 may be completely covered by the passivation layer 900 on the bottom surface of the display device 10.

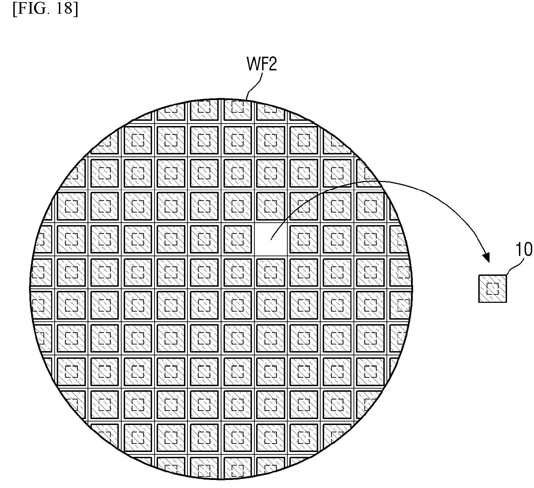

In addition, in plan view, the passivation layer 900 may have the same area as the second single crystal semiconductor substrate 210, and the side surface of the passivation layer 900 may be parallel to the side surface of the second single crystal semiconductor substrate 210. The passivation layer 900 may be separated together with the second single crystal semiconductor substrate 210 when the second single crystal semiconductor substrate 210 is separated from a wafer substrate WF2 (see FIG. 18) in the fabricating process of the display device 10, and the area of the passivation layer 900 in plan view may be equal to the area of the second single crystal semiconductor substrate 210 in plan view. Even if the display device 10 includes the first single crystal semiconductor substrate 110 and the second single crystal semiconductor substrate 210 having the different areas in plan view, all partial steps may be compensated by the passivation layer 900 to ensure structural stability.

Hereinafter, the structure of the driving circuit layer 120 of the driving part 100 and the display element layer 230 of the display part 200 will be described in detail with reference to other drawings.

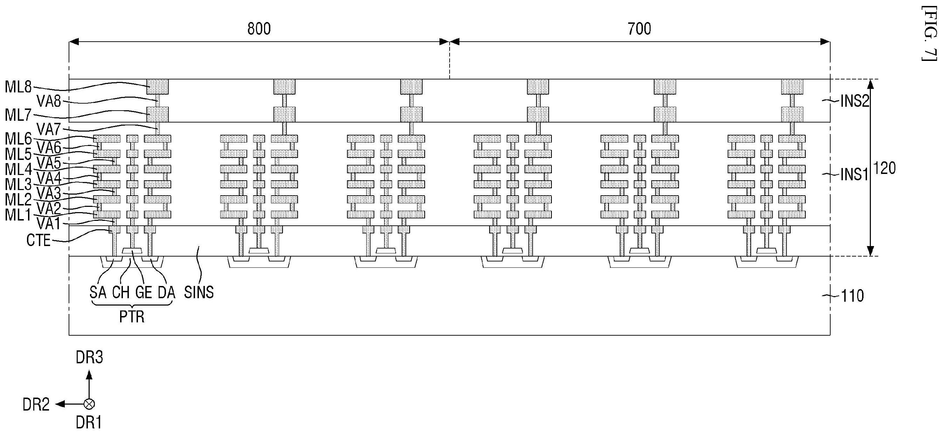

FIG. 7 is a schematic cross-sectional view of a driving part according to one embodiment.

Referring to FIG. 7, the driving part 100 may include the first single crystal semiconductor substrate 110 and the driving circuit layer 120 disposed thereon. FIG. 7 schematically shows the cross-sectional structure of the data driver 700 and the pixel circuit part 800 among the circuit parts disposed in the driving part 100.

The first single crystal semiconductor substrate 110 may be a silicon substrate, a germanium substrate, or a silicon-germanium substrate. The first single crystal semiconductor substrate 110 may be a substrate doped with a first type impurity. A plurality of well regions may be disposed on the top surface of the first single crystal semiconductor substrate 110. The plurality of well regions may be regions doped with a second type impurity. The second type impurity may be different from the aforementioned first type impurity. For example, when the first type impurity is a p-type impurity, the second type impurity may be an n-type impurity. Alternatively, when the first type impurity is an n-type impurity, the second type impurity may be a p-type impurity.

The first single crystal semiconductor substrate 110 and the driving circuit layer 120 on the first single crystal semiconductor substrate 110 may include a plurality of transistors PTR constituting a plurality of circuit elements of the driving part 100. Each of the well regions in the first single crystal semiconductor substrate 110 may include a source region SA corresponding to the source electrode of the transistor PTR, a drain region DA corresponding to the drain electrode of the transistor PTR, and a channel region CH disposed between the source region SA and the drain region DA.

In one embodiment where the first single crystal semiconductor substrate 110 is doped with the first type impurity, each of the source region SA and the drain region DA may be doped with the first type impurity. A gate electrode GE may be disposed to overlap the well region between the source region SA and the drain region DA, and the channel region CH may be formed between the source region SA and the drain region DA. A part of a semiconductor insulating layer SINS may overlap the gate electrode GE, and may be disposed between the gate electrode GE and the well region. The source region SA, the channel region CH, and the drain region DA of the transistor PTR may be disposed within a first single-crystal semiconductor substrate 110, and the gate electrode GE of the transistor PTR may be disposed on the first single-crystal semiconductor substrate 110.

In some embodiments, both ends of the gate electrode GE and the portion of the semiconductor insulating layer SINS overlapping the gate electrode GE may partially overlap the source region SA and the drain region DA, respectively. The transistors PTR constituting the pixel circuit part 800 illustrated in FIG. 7 may be the first to sixth transistors T1 to T6 described above with reference to FIG. 5. The transistors PTR of the data driver 700 may be transistors constituting circuits such as the timing control circuit 410 and the power supply circuit 420.

When the driving circuit layer 120 is formed on a silicon wafer substrate, a process of reducing the thickness of the first single crystal semiconductor substrate 110 may be performed. The first single crystal semiconductor substrate 110 may have a thickness smaller than that of a wafer substrate on which a semiconductor process for forming the driving circuit layer 120 is performed. In some embodiments, the thickness of the first single crystal semiconductor substrate 110 may be 100 µm or less, for example, in the range of 80 µm to 100 µm.

The driving circuit layer 120 may include the semiconductor insulating layer SINS, a plurality of contact electrodes CTE, a first interlayer insulating layer INS1, a second interlayer insulating layer INS2, a plurality of conductive layers ML1 to ML8, and a plurality of vias VA1 to VA8. The driving circuit layer 120 may include wires electrically connected to the plurality of transistors PTR included in the first single crystal semiconductor substrate 110.

The semiconductor insulating layer SINS may be disposed on the first single crystal semiconductor substrate 110. The semiconductor insulating layer SINS may be formed of silicon carbonitride (SiCN) or a silicon oxide (SiOₓ)-based inorganic layer, but is not limited thereto. In the drawings, the semiconductor insulating layer SINS is illustrated as being formed as a single layer having a predetermined thickness, but the disclosure is not limited thereto. The semiconductor insulating layer SINS may have a structure in which one or more layers are stacked on top of each other.

The plurality of contact electrodes CTE may be disposed on the first single crystal semiconductor substrate 110. The plurality of contact electrodes CTE may be connected to any one of the gate electrodes GE, the source region SA, and the drain region DA of each transistor PTR formed on the first single crystal semiconductor substrate 110 through holes penetrating the semiconductor insulating layer SINS. The plurality of contact electrodes CTE may be formed of any one of copper (Cu), aluminium (Al), tungsten (W), molybdenum (Mo), chromium (Cr), gold (Au), titanium (Ti), nickel (Ni), and neodymium (Nd), or an alloy including any one of them. The top surfaces of the plurality of contact electrodes CTE may be exposed without being covered by the semiconductor insulating layer SINS.

The first interlayer insulating layer INS1 may be disposed on the plurality of contact electrodes CTE and the semiconductor insulating layer SINS. The second interlayer insulating layer INS2 may be disposed on the first interlayer insulating layer INS1. Each of the first interlayer insulating layer INS1 and the second interlayer insulating layer INS2 may be formed of silicon carbonitride (SiCN) or a silicon oxide (SiOₓ)-based inorganic layer, but is not limited thereto. Although it is illustrated in the drawings that each of the first interlayer insulating layer INS1 and the second interlayer insulating layer INS2 is formed as a single layer, the disclosure is not limited thereto. Each of the first interlayer insulating layer INS1 and the second interlayer insulating layer INS2 may have a structure in which one or more layers are stacked on top of each other, and may be disposed between the plurality of first to eighth conductive layers ML1 to ML8 to be described later.

The first to eighth conductive layers ML1 to ML8 and the first to eighth vias VA1 to VA8 may be electrically connected to the plurality of contact electrodes CTE to form the circuit parts or the drivers of the driving part 100. The plurality of transistors PTR included in the first single crystal semiconductor substrate 110 may be electrically connected to each other through the first to eighth conductive layers ML1 to ML8 and the first to the eighth vias VA1 to VA8, and may form the driving circuit part 400, the gate driver 600, the data driver 700, and the pixel circuit part 800 of the driving part 100. For example, the first to sixth transistors T1 to T6 included in the pixel circuit of the sub-pixel SP shown in FIG. 5 may be the plurality of transistors PTR included in the first single crystal semiconductor substrate 110, and connections of the first to sixth transistors T1 to T6 and the first and second capacitors C1 and C2 may be formed through the first to eighth conductive layers ML1 to ML8.

The first conductive layer ML1 may be connected to the contact electrode CTE through the first via VA1. The first conductive layer ML1 may be disposed on the contact electrode CTE, and the first via VA1 may be disposed between the first conductive layer ML1 and the contact electrode CTE to be in contact with both of them. The second conductive layer ML2 may be connected to the first conductive layer ML1 through the second via VA2. The second conductive layer ML2 may be disposed on the first conductive layer ML1, and the second via VA2 may be disposed between the first conductive layer ML1 and the second conductive layer ML2 to be in contact with both of them.

The third conductive layer ML3 may be connected to the second conductive layer ML2 through the third via VA3. The fourth conductive layer ML4 may be connected to the third conductive layer ML3 through the fourth via VA4, the fifth conductive layer ML5 may be connected to the fourth conductive layer ML4 through the fifth via VA5, and the sixth conductive layer ML6 may be connected to the fifth conductive layer ML5 through the sixth via VA6. The third conductive layer ML3, the fourth conductive layer ML4, the fifth conductive layer ML5, and the sixth conductive layer ML6 may be sequentially disposed on the second conductive layer ML2, and the third via VA3, the fourth via VA4, the fifth via VA5, and the sixth via VA6 may be disposed between them. The third to sixth vias VA6 may be in contact with different metal layers disposed above and below them, respectively. The seventh via VA7 may be disposed on the sixth conductive layer ML6. The seventh via VA7 may be in contact with the seventh conductive layer ML7 and the sixth conductive layer ML6 disposed thereon.

The first to sixth conductive layers ML1 to ML6 and the first to seventh vias VA1 to VA7 may be disposed in the first interlayer insulating layer INS1. The first to sixth conductive layers ML1 to ML6 and the first to seventh vias VA1 to VA7 may constitute a first driving circuit layer disposed in the first interlayer insulating layer INS 1 of the driving circuit layer 120.

The seventh conductive layer ML7 may be connected to the sixth conductive layer ML6 through the seventh via VA7. The seventh conductive layer ML7 may be disposed on the first interlayer insulating layer INS1 and the sixth conductive layer ML6, and the seventh via VA7 may be disposed between the sixth conductive layer ML6 and the seventh conductive layer ML7 to be in contact with both of them. The eighth conductive layer ML8 may be connected to the seventh conductive layer ML7 through the eighth via VA8. The eighth conductive layer ML8 is disposed on the seventh conductive layer ML7, and the eighth via VA8 may be disposed between the seventh conductive layer ML7 and the eighth conductive layer ML8 to be in contact with both of them. The top surface of the eighth conductive layer ML8 may be exposed without being covered by the second interlayer insulating layer INS2, and may be electrically connected to the routing lines RM1 and RM2 disposed in the display part 200.

The seventh conductive layer ML7, the eighth via VA8, and the eighth conductive layer ML8 may be disposed in the second interlayer insulating layer INS2. The seventh conductive layer ML7, the eighth via VA8, and the eighth conductive layer ML8 may constitute a second driving circuit layer disposed in the second interlayer insulating layer INS2 of the driving circuit layer 120.

In the drawings, although the first to eighth conductive layers ML1 to ML8 and the first to eighth vias VA1 to VA8 are illustrated as being sequentially stacked on top of each other, their layout and connection may be modified in various ways according to the circuits of the driving circuit part 400, the gate driver 600, the data driver 700, and the pixel circuit part 800 of the driving part 100. The connection structure shown in the drawings is nothing more than an example, and the connection of the driving circuit layer 120 disposed in the driving part 100 of the display device 10 is not limited thereto. In addition, the driving circuit layer 120 may not necessarily include first to eighth conductive layers ML1 to ML8 and the first to eighth vias VA1 to VA8, and some of these layers may be omitted or more layers may be provided.

The first to eighth conductive layers ML1 to ML8 and the first to eighth vias VA1 to VA8 may be formed of substantially the same material. For example, the first to eighth conductive layers ML1 to ML8 and the first to eighth vias VA1 to VA8 may be formed of any one of copper (Cu), aluminium (Al), tungsten (W), molybdenum (Mo), chromium (Cr), gold (Au), titanium (Ti), nickel (Ni), and neodymium (Nd), or an alloy including any one of them.

The thicknesses of the first conductive layer ML1, the second conductive layer ML2, the third conductive layer ML3, the fourth conductive layer ML4, the fifth conductive layer ML5, and the sixth conductive layer ML6 may be larger than the thicknesses of the first via VA1, the second via VA2, the third via VA3, the fourth via VA4, the fifth via VA5, and the sixth via VA6, respectively. The thickness of each of the second conductive layer ML2, the third conductive layer ML3, the fourth conductive layer ML4, the fifth conductive layer ML5, and the sixth conductive layer ML6 may be larger than the thickness of the first conductive layer ML1. The thickness of the second conductive layer ML2, the thickness of the third conductive layer ML3, the thickness of the fourth conductive layer ML4, the thickness of the fifth conductive layer ML5, and the thickness of the sixth conductive layer ML6 may be substantially the same. For example, the thickness of the first conductive layer ML1 may be approximately 1360Å; the thickness of each of the second conductive layer ML2, the third conductive layer ML3, the fourth conductive layer ML4, the fifth conductive layer ML5, and the sixth conductive layer ML6 may be approximately 1440Å; and the thickness of each of the first via VA1, the second via VA2, the third via VA3, the fourth via VA4, the fifth via VA5, and the sixth via VA6 may be approximately 1150Å.

The thickness of each of the seventh conductive layer ML7 and the eighth conductive layer ML8 may be larger than the thickness of the first conductive layer ML1, the thickness of the second conductive layer ML2, the thickness of the third conductive layer ML3, the thickness of the fourth conductive layer ML4, the thickness of the fifth conductive layer ML5, and the sixth conductive layer ML6. The thickness of the seventh conductive layer ML7 and the thickness of the eighth conductive layer ML8 may be larger than the thickness of the seventh via VA7 and the thickness of the eighth via VA8, respectively. The thickness of each of the seventh via VA7 and the eighth via VA8 may be larger than the thickness of the first via VA1, the thickness of the second via VA2, the thickness of the third via VA3, the thickness of the fourth via VA4, the thickness of the fifth via VA5, and the thickness of the sixth via VA6. The thickness of the seventh conductive layer ML7 and the thickness of the eighth conductive layer ML8 may be substantially the same. For example, the thickness of each of the seventh conductive layer ML7 and the eighth conductive layer ML8 may be approximately 9000 Å. The thickness of each of the seventh via VA7 and the eighth via VA8 may be approximately 6000 Å.

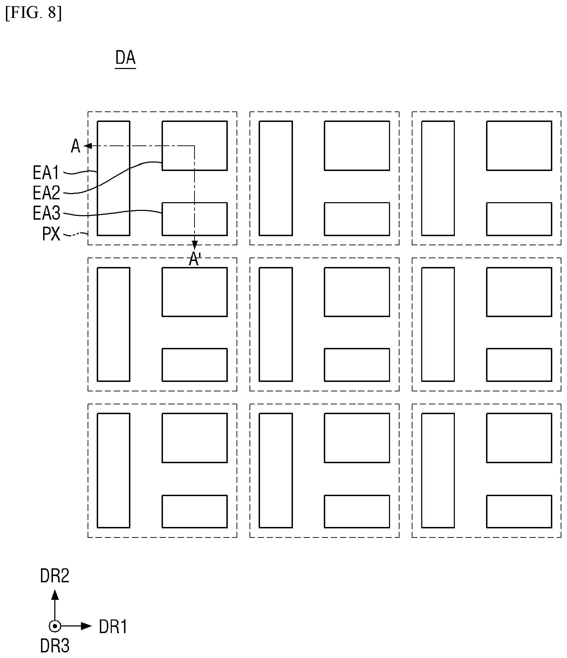

FIG. 8 is a plan view illustrating the layout of pixels disposed in a display area of a display part according to one embodiment. FIG. 9 is a cross-sectional view taken along line A-A' of FIG. 8.

Referring to FIGS. 8 and 9, each of the plurality of pixels PX may include a first emission area EA1, a second emission area EA2, and a third emission area EA3, which are emission areas of the plurality of different sub-pixels SP.

Each of the first emission area EA1, the second emission area EA2, and the third emission area EA3 may have, in plan view, a quadrilateral shape such as a rectangle, a square, or a diamond. For example, the first emission area EA1 may have a rectangular shape, in plan view, having a short side in the first direction DR1 and a long side in the second direction DR2. In addition, each of the second emission area EA2 and the third emission area EA3 may have a rectangular shape, in plan view, having a long side in the first direction DR1 and a short side in the second direction DR2.

The length of the first emission area EA1 in the first direction DR1 may be smaller than the length of the second emission area EA2 in the first direction DR1, and may be smaller than the length of the third emission area EA3 in the first direction DR1. The length of the second emission area EA2 in the first direction DR1 and the length of the third emission area EA3 in the first direction DR1 may be substantially the same.

The length of the first emission area EA1 in the second direction DR2 may be larger than the sum of the length of the second emission area EA2 in the second direction DR2 and the length of the third emission area EA3 in the second direction DR2. The length of the second emission area EA2 in the second direction DR2 may be smaller than the length of the third emission area EA3 in the second direction DR2.

Although it is illustrated in FIG. 8 that each of the first emission area EA1, the second emission area EA2, and the third emission area EA3 has a rectangular shape in plan view, the disclosure is not limited thereto. For example, each of the first emission area EA1, the second emission area EA2, and the third emission area EA3 may have a planar shape other than a quadrilateral shape, such as a circular shape, or an elliptical shape.

In each of the plurality of pixels PX, the first emission area EA1 and the second emission area EA2 may be adjacent to each other in the first direction DR1. Further, the first emission area EA1 and the third emission area EA3 may be adjacent to each other in the first direction DR1. In addition, the second emission area EA2 and the third emission area EA3 may be adjacent to each other in the second direction DR2. The area of the first emission area EA1, the area of the second emission area EA2, and the area of the third emission area EA3 may be different.

The first emission area EA1 may emit light of a first color, the second emission area EA2 may emit light of a second color, and the third emission area EA3 may emit light of a third color. Here, the first color light may be light of a blue wavelength band, the second color light may be light of a green wavelength band, and the third color light may be light of a red wavelength band. For example, the light of the blue wavelength band indicates light whose main peak wavelength is included in the wavelength band ranging from about 370 nm to about 460 nm; the light of the green wavelength band indicates light whose main peak wavelength is included in the wavelength band ranging from about 480 nm to about 560 nm; and the light of the red wavelength band indicates light whose main peak wavelength is included in the wavelength band ranging from about 600 nm to about 750 nm.

Although it is illustrated in FIG. 8 that each of the plurality of pixels PX includes the three emission areas EA1, EA2, and EA3, the disclosure is not limited thereto. That is, each of the plurality of pixels PX may include four emission areas.

In addition, the layout of the emission areas of the plurality of pixels PX is not limited to that illustrated in FIG. 8. For example, the emission areas of the plurality of pixels PX may be arranged in a stripe structure in which the emission areas are arranged in the first direction DR1, a PenTile^{®} structure in which the emission areas are arranged in a diamond shape, or a hexagonal structure in which the emission areas having, in plan view, a hexagonal shape are arranged.

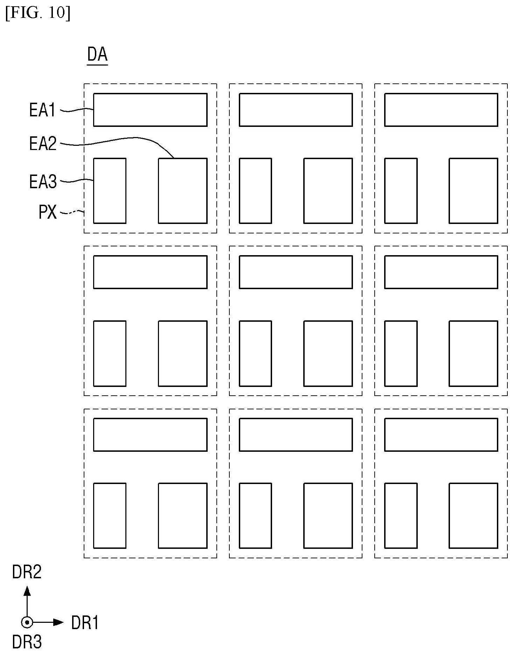

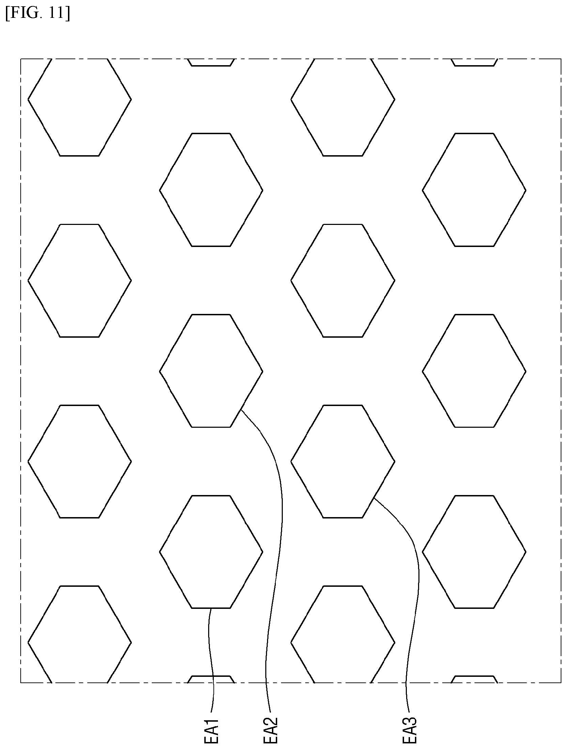

FIGS. 10 and 11 are plan views illustrating the layout of a display area of a display part according to another embodiment.

Referring to FIGS. 10 and 11, in the display device 10 according to one embodiment, the layout of the emission areas EA1, EA2, and EA3 of the display part 200 may be different from that shown in in FIG. 8. For example, in the display device 10 of FIG. 10, the first emission area EA1 and the second emission area EA2 may be adjacent in the second direction DR2 in each of the plurality of pixels PX. Further, the first emission area EA1 and the third emission area EA3 may be adjacent to each other in the second direction DR2. Further, the second emission area EA2 and the third emission area EA3 may be adjacent to each other in the first direction DR1. The area of the first emission area EA1, the area of the second emission area EA2, and the area of the third emission area EA3 may be different. Although the first emission area EA1 in the display device 10 of FIG. 8 has a shape extending in the second direction DR2, the first emission area EA1 in the display device 10 of FIG. 10 may have a shape extending in the first direction DR1. In the display device 10 of FIG. 11, each of the first emission area EA1, the second emission area EA2, and the third emission area EA3 may have a hexagonal shape in plan view, and they may be arranged while being spaced apart from each other in a diagonal direction. In the drawings, it is illustrated that the first emission area EA1 and the second emission area EA2 are spaced from each other in a horizontal direction, and the third emission area EA3 is spaced apart from each of the first emission area EA1 and the second emission area EA2 in a diagonal direction. However, the arrangement of the plurality of emission areas EA1, EA2, and EA3 is not limited thereto.

Referring to FIG. 9, the display part 200 may include the second single crystal semiconductor substrate 210, a reflective layer MIL, a light emitting element layer EML, an encapsulation layer TFE, an optical layer OPL, and a cover layer CVL. The connection wiring layer 220 may be disposed between the light emitting element layer EML and the first single crystal semiconductor substrate 110.

The second single crystal semiconductor substrate 210 may be a silicon substrate, a germanium substrate, or a silicon-germanium substrate. The second single crystal semiconductor substrate 210 may be a substrate doped with an impurity. However, the disclosure is not limited thereto. The second single crystal semiconductor substrate 210 may be a silicon substrate that is not doped with an impurity. Unlike the first single crystal semiconductor substrate 110, the second single crystal semiconductor substrate 210 may not include a plurality of transistors. The second single crystal semiconductor substrate 210 may be a base member on which the light emitting element layer EML is disposed, and circuit elements may not be formed thereon, unlike the first single crystal semiconductor substrate 110.

The second single crystal semiconductor substrate 210 may include a plurality of through holes SVA spaced apart from each other. The through hole SVA may penetrate the second single crystal semiconductor substrate 210 from the top surface to the bottom surface thereof, and a conductive via RVA of the routing line RM1 (RM2) may be disposed therein. The through hole SVA may form a connection passage of the routing lines RM1 and RM2 serving to electrically connect the circuit elements of the driving part 100 to the light emitting elements of the display part 200. In some embodiments, the through hole SVA of the second single crystal semiconductor substrate 210 may be formed through a through silicon via (TSV) process in which a hole that penetrates the wafer substrate is formed. Through the through hole SVA formed in the second single crystal semiconductor substrate 210, the display element layer 230 and the driving part 100 may be electrically connected to each other through the routing lines RM1 and RM2 without an additional wire.

A process of reducing the thickness of the second single crystal semiconductor substrate 210 may be performed after the driving part 100 is bonded on the silicon wafer substrate. The second single crystal semiconductor substrate 210 may have a thickness thinner than that of the wafer substrate on which a process for forming conductive layers is performed. In some embodiments, the thickness of the second single crystal semiconductor substrate 210 may be 100 µm or less, for example, in the range of 80 µm to 100 µm.

The connection wiring layer 220 may be disposed on the bottom surface of the second single crystal semiconductor substrate 210. The connection wiring layer 220 may include a third interlayer insulating layer INS3, the plurality of connection lines RML, and a ninth via VA9.

The third interlayer insulating layer INS3 may be disposed on the bottom surface of the second single crystal semiconductor substrate 210. The third interlayer insulating layer INS3 may be formed of a silicon carbonitride (SiCN) or a silicon oxide (SiOₓ)-based inorganic layer, but is not limited thereto. In the drawings, the third interlayer insulating layer INS3 is illustrated as being formed as a single layer. However, the disclosure is not limited thereto, and the third interlayer insulating layer INS3 may have a structure in which one or more layers are stacked on top of each other, and these layers may be disposed between the connection lines RML.

The connection lines RML may form a routing line RM of the connection wiring layer 220 together with the ninth via VA9 and the conductive via RVA. The connection line RML may include one or more conductive layers, and one or more vias connecting them to each other. The connection and the structure of the connection lines RML may be the same as those of the plurality of conductive layers ML1 to ML8 and the plurality of vias VA1 to VA8 described above. The connection line RML may be electrically connected to the light emitting element of the light emitting element layer EML through the conductive via RVA disposed in the through hole SVA of the second single crystal semiconductor substrate 210, and may be electrically connected to the driving circuit layer 120 of the driving part 100 through the ninth via VA9.

According to one embodiment, at least some of the through holes SVA, the connection lines RML, and the conductive vias RVA may respectively overlap the display area DAA in the thickness direction. For example, at least some of the through holes SVA, the connection lines RML, and the conductive vias RVA may respectively overlap the emission areas EA1, EA2, and EA3 of the light emitting element layer EML in the thickness direction. Since each of the light emitting elements disposed in the emission areas EA1, EA2, and EA3 of the light emitting element layer EML is connected to the pixel circuit part 800 through the routing line RM1 (RM2), the connection lines RML may overlap the respective light emitting elements in the thickness direction and may be electrically connected to them.

Since the routing line RM electrically connects the light emitting elements LE disposed on the second single crystal semiconductor substrate 210 to the pixel circuit part 800 of the first single crystal semiconductor substrate 110, the layout of the connection lines RML, the through holes SVA, and the conductive vias RVA may be modified in various ways according to the relative arrangement of the light emitting element layer EML and the first single crystal semiconductor substrate 110.

For example, as the connection wiring layer 220 is disposed on the bottom surface of the second single crystal semiconductor substrate 210, the through holes SVA and the conductive vias RVA may be disposed across the entire light emitting element layer EML, and the connection lines RML may be disposed across the entire surface of the second single crystal semiconductor substrate 210 while being concentrated in the region where the first single crystal semiconductor substrate 110 is located. According to one embodiment, in the display device 10, the plurality of through holes SVA and the conductive vias RVA may overlap the light emitting element layer EML in the thickness direction, and at least some of the through holes SVA and at least some of the conductive vias RVA may not overlap the first single crystal semiconductor substrate 110 in the thickness direction. As described above, the area of the first single crystal semiconductor substrate 110 in plan view may be smaller than the area of the second single crystal semiconductor substrate 210 in plan view, and only some of the through holes SVA and some of the conductive vias RVA disposed across the entire surface of the second single crystal semiconductor substrate 210 may overlap the first single crystal semiconductor substrate 110 in the thickness direction.

At least some of the connection lines RML may not overlap the first single crystal semiconductor substrate 110 in the thickness direction. The connection lines RML may electrically connect the plurality of through holes SVA and the conductive vias RVA disposed across the entire surface of the second single crystal semiconductor substrate 210 to the pixel circuit part 800 of the first single crystal semiconductor substrate 110. Accordingly, some of the connection lines RML may not overlap the first single crystal semiconductor substrate 110, but an end of the connection line RML composed of multiple layers may overlap the thickness of the first single crystal semiconductor substrate 110 in the thickness direction. The connection line RML may form a path for electrically connecting the light emitting elements disposed across the entire display area DAA having a larger area to the pixel circuit part 800 having a smaller area.

The reflective layer MIL may be disposed on the second single crystal semiconductor substrate 210. The reflective layer MIL may include one or more layers of reflective electrodes RL1, RL2, RL3, and RL4. Each of the plurality of reflective electrodes RL1, RL2, RL3, and RL4 of the reflective layer MIL may be disposed to overlap the emission areas EA1, EA2, and EA3. When light emitted from the light emitting element layer EML disposed on the reflective layer MIL is emitted toward the second single crystal semiconductor substrate 210, the reflective layer MIL may reflect the light toward an upper portion of the display part 200. In addition, the reflective layer MIL may be formed of a conductive metal layer and electrically connected to each of a first electrode AND of the light emitting element and the connection line RML.

Each of the first reflective electrodes RL1 may be disposed on the third interlayer insulating layer INS3, and may be connected to the ninth via VA9. The first reflective electrodes RL1 may be formed of any one of copper (Cu), aluminium (Al), tungsten (W), molybdenum (Mo), chromium (Cr), gold (Au), titanium (Ti), nickel (Ni), and neodymium (Nd), or an alloy including any one of them.

Each of the second reflective electrodes RL2 may be disposed on the first reflective electrode RL1. The second reflective electrodes RL2 may be formed of any one of copper (Cu), aluminium (Al), tungsten (W), molybdenum (Mo), chromium (Cr), gold (Au), titanium (Ti), nickel (Ni), and neodymium (Nd), or an alloy including any one of them. For example, the second reflective electrodes RL2 may be made of titanium nitride (TiN).

A stepped layer STPL may be disposed on the second reflective electrode RL2 overlapping the first emission area EA1. The stepped layer STPL may not be disposed on the second reflective electrode RL2 overlapping the second emission area EA2 and the third emission area EA3. In order to facilitate the reflection of light emitted from an intermediate layer IL, the thickness of the stepped layer STPL may be set in consideration of the wavelength of the light and a distance from the second electrode CAT of the light emitting element to the fourth reflective electrode RL4. The stepped layer STPL may be formed of a silicon carbon nitride (SiCN) or silicon oxide (SiOₓ)-based inorganic layer, but is not limited thereto. The thickness of the stepped layer STPL may be about 400 Å.

In the first emission area EA1, the third reflective electrode RL3 may be disposed on the second reflective electrode RL2 and the stepped layer STPL. In the second emission area EA2 and the third emission area EA3, the third reflective electrode RL3 may be disposed on the second reflective electrode RL2. The third reflective electrodes RL3 may be formed of any one of copper (Cu), aluminium (Al), tungsten (W), molybdenum (Mo), chromium (Cr), gold (Au), titanium (Ti), nickel (Ni), and neodymium (Nd), or an alloy including any one of them.

At least one of the first reflective electrode RL1, the second reflective electrode RL2, or the third reflective electrode RL3 may be omitted.

The fourth reflective electrodes RL4 may be respectively disposed on the third reflective electrodes RL3. The fourth reflective electrodes RL4 may reflect light from first to third intermediate layers IL1, IL2, and IL3. Among the plurality of reflective electrodes RL1, RL2, RL3, and RL4, at least the uppermost fourth reflective electrode RL4 may include a metal having a high reflectance to facilitate light reflection. The fourth reflective electrodes RL4 may be formed of aluminium (Al), a stacked structure (Ti/Al/Ti) of aluminium and titanium, a stacked structure (ITO/Al/ITO) of aluminium and ITO, an APC alloy, which is an alloy of silver (Ag), palladium (Pd), and copper (Cu), and a stacked structure (ITO/APC/ITO) of the APC alloy and ITO, but are not limited thereto. Each of the fourth reflective electrodes RL4 may have a thickness of about 850 Å.

Meanwhile, a method of setting light emitted from the intermediate layer IL to be advantageously reflected by the reflective layer MIL is not limited to providing the stepped layer STPL. Depending on the thickness of a fourth interlayer insulating layer INS4 disposed between the first electrode AND of the light emitting element and the fourth reflective electrode RL4, the reflection of light emitted from the intermediate layer IL may be advantageous. In the display device 10, the thickness of the fourth interlayer insulating layer INS4 disposed between the first electrode AND of the light emitting element and the fourth reflective electrode RL4 in some emission areas EA1, EA2, and EA3 may be adjusted in consideration of the wavelengths of light emitted from different emission areas EA1, EA2, and EA3.

In the display device 10 of the embodiment of FIG. 9, the stepped layer STPL is disposed to overlap the light emitting element in the first emission area EA1, while the stepped layer STPL is not disposed in the second emission area EA2 and the third emission area EA3. However, the disclosure is not limited thereto, and the stepped layer STPL may be further disposed in at least one of the second emission area EA2 or the third emission area EA3. Alternatively, the stepped layer STPL may not be disposed and the thickness of the fourth interlayer insulating layer INS4 may vary between the first electrodes AND of the light emitting elements and the fourth reflective electrodes RL4.

The fourth interlayer insulating layer INS4 may be disposed on the third interlayer insulating layer INS3 and the fourth reflective electrodes RL4. The fourth interlayer insulating layer INS4 may be formed of a silicon carbon nitride (SiCN) or silicon oxide (SiOₓ)-based inorganic layer, but is not limited thereto. In the drawing, it is exemplified that the fourth interlayer insulating layer INS4 is formed of a single layer, but is not limited thereto. The fourth interlayer insulating layer INS4 may have a structure in which at least one or more layers are stacked on each other.

A tenth via VA10 may be disposed between the fourth reflective electrode RL4 and the light emitting element layer EML. The tenth via VA10 may be disposed between the fourth reflective electrode RL4 and the first electrode AND of the light emitting element layer EML and may be connected to each of them. The tenth via VA10 may be formed of any one of copper (Cu), aluminium (Al), tungsten (W), molybdenum (Mo), chromium (Cr), gold (Au), titanium (Ti), nickel (Ni), and neodymium (Nd), or an alloy including any one of them. Due to the stepped layer STPL, the thickness of the tenth via VA10 overlapping the first emission area EA1 may be smaller than the thickness of the tenth via VA10 in each of the second emission area EA2 and the third emission area EA3. For example, the thickness of the tenth via VA10 in the first emission area EA1 may be approximately 800 Å, and the thicknesses of the tenth via VA10 in each of the second emission area EA2 and the third emission area EA3 may be approximately 1200 Å.

The light emitting element layer EML may be disposed on the fourth interlayer insulating layer INS4. The light emitting element layer EML may include the light emitting elements LE each having the first electrode AND, the intermediate layer IL, and the second electrode CAT, a pixel defining layer PDL, and a plurality of trenches TRC.

The first electrode AND of each of the light emitting elements LE may be disposed on the fourth interlayer insulating layer INS4 and connected to the tenth via VA10. The first electrode AND of each of the light emitting elements LE may be electrically connected to the pixel circuit part 800 of the driving part 100 through the tenth via VA10, the first to fourth reflective electrodes RL1 to RL4, and the connection line RML of the connection wiring layer 220. The first electrode AND of each of the light emitting elements LE may be formed of any one of copper (Cu), aluminium (Al), tungsten (W), molybdenum (Mo), chromium (Cr), gold (Au), titanium (Ti), nickel (Ni), and neodymium (Nd), or an alloy including any one of them. For example, the first electrode AND of each of the light emitting elements LE may be titanium nitride (TiN).

The pixel defining layer PDL may be disposed on a part of the first electrode AND of each of the light emitting elements LE. The pixel defining layer PDL may cover the edge of the first electrode AND of each of the light emitting elements LE. The pixel defining layer PDL may partition the first emission areas EA1, the second emission areas EA2, and the third emission areas EA3.

The first emission area EA1 may be defined as an area in which the first electrode AND, the intermediate layer IL, and the second electrode CAT are sequentially stacked in the first sub-pixel to emit light. The second emission area EA2 may be defined as an area in which the first electrode AND, the intermediate layer IL, and the second electrode CAT are sequentially stacked in the second sub-pixel to emit light. The third emission area EA3 may be defined as an area in which the first electrode AND, the intermediate layer IL, and the second electrode CAT are sequentially stacked in the third sub-pixel to emit light.

The pixel defining layer PDL may include first to third pixel defining layers PDL1, PDL2, and PDL3. The first pixel defining layer PDL1 may be disposed on the edge of the first electrode AND of each of the light emitting elements LE, the second pixel defining layer PDL2 may be disposed on the first pixel defining layer PDL1, and the third pixel defining layer PDL3 may be disposed on the second pixel defining layer PDL2. The first pixel defining layer PDL1, the second pixel defining layer PDL2, and the third pixel defining layer PDL3 may be formed of a silicon oxide (SiOₓ)-based inorganic layer, but are not limited thereto. The first pixel defining layer PDL1, the second pixel defining layer PDL2, and the third pixel defining layer PDL3 may each have a thickness of about 500 Å.

Each of the plurality of trenches TRC may penetrate the first pixel defining layer PDL1, the second pixel defining layer PDL2, and the third pixel defining layer PDL3. The fourth interlayer insulating layer INS4 may be partially recessed at each of the plurality of trenches TRC.

At least one trench TRC may be disposed between adjacent emission areas EA1, EA2, and EA3. Although FIG. 9 illustrates that two trenches TRC are disposed between adjacent emission areas EA1, EA2, and EA3, the disclosure is not limited thereto. In a process of forming the intermediate layer IL to be described later, the trench TRC may prevent the connection of the material of the intermediate layer IL between different emission areas EA1, EA2, and EA3 or openings of the pixel defining layer PDL.

The intermediate layer IL may include the first intermediate layer IL1, the second intermediate layer IL2, and the third intermediate layer IL3.

The intermediate layer IL may have a tandem structure including the plurality of intermediate layers IL1, IL2, and IL3 that emit different lights. For example, the intermediate layer IL may include the first intermediate layer IL1 that emits light of the first color, the second intermediate layer IL2 that emits light of the third color, and the third intermediate layer IL2 that emits light of the second color. The first intermediate layer IL1, the second intermediate layer IL2, and the third intermediate layer IL3 may be sequentially stacked. The stacking order of the first to third intermediate layers IL1, IL2, and IL3 that emit light of different colors may be varied.

The first intermediate layer IL1 may have a structure in which a first hole transport layer, a first organic light emitting layer that emits light of the first color, and a first electron transport layer are sequentially stacked. The second intermediate layer IL2 may have a structure in which a second hole transport layer, a second organic light emitting layer that emits light of the third color, and a second electron transport layer are sequentially stacked. The third intermediate layer IL3 may have a structure in which a third hole transport layer, a third organic light emitting layer that emits light of the second color, and a third electron transport layer are sequentially stacked.

A first charge generation layer for supplying charges to the second intermediate layer IL2 and supplying electrons to the first intermediate layer IL1 may be disposed between the first intermediate layer IL1 and the second intermediate layer IL2. A second charge generation layer for supplying charges to the third intermediate layer IL3 and supplying electrons to the second intermediate layer IL2 may be disposed between the second intermediate layer IL2 and the third intermediate layer IL3.

The first intermediate layer IL1 may be disposed on the first electrodes AND and the pixel defining layer PDL, and may be disposed on the bottom surface of each trench TRC. Due to the trench TRC, the first intermediate layer IL1 may be separated between adjacent emission areas EA1, EA2, and EA3. The second intermediate layer IL2 may be disposed on the first intermediate layer IL1. Due to the trench TRC, the second intermediate layer IL2 may be separated between adjacent emission areas EA1, EA2, and EA3. The third intermediate layer IL3 may be disposed on the second intermediate layer IL2. Due to the trench TRC, the third intermediate layer IL3 may be separated between adjacent emission areas EA1, EA2, and EA3. That is, each of the plurality of trenches TRC may be a structure for separating the first to third intermediate layers IL1, IL2, and IL3 of the light emitting element layer EML between adjacent emission areas EA1, EA2, and EA3.

In order to stably separate the first to third intermediate layers IL1, IL2, and IL3 of the light emitting element layer EML between adjacent emission areas EA1, EA2, and EA3, the depth of each of the plurality of trenches TRC may be greater than the height of the pixel defining layer PDL. The depth of each of the plurality of trenches TRC may be the length of the trench TRC measured in the third direction DR3. The height of the pixel defining layer PDL may be the length of the pixel defining layer PDL measured in the third direction DR3.

In some embodiments, another structure may be disposed in place of the trench TRC to separate the first to third intermediate layers IL1, IL2, and IL3 of the light emitting element layer EML between adjacent emission areas EA1, EA2, and EA3. For example, a reverse tapered partition wall may be disposed on the pixel defining layer PDL between adjacent emission areas EA1, EA2, and EA3.

The number of the intermediate layers IL1, IL2, and IL3 that emit different light is not limited to that shown in FIG. 9. For example, the intermediate layer IL may include two intermediate layers. In this case, one of the two intermediate layers may be substantially the same as the first intermediate layer IL1, and the other may include a second hole transport layer, a second organic light emitting element layer, a third organic light emitting layer, and a second electron transport layer. In this case, a charge generation layer for supplying electrons to one intermediate layer and supplying charges to the other intermediate layer may be disposed between the two intermediate layers.

In addition, FIG. 9 illustrates that the first to third intermediate layers IL1, IL2, and IL3 are all disposed in the first emission area EA1, the second emission area EA2, and the third emission area EA3, but the disclosure is not limited thereto. For example, the first intermediate layer IL1 may be disposed in the first emission area EA1 and may not be disposed in the second emission area EA2 and the third emission area EA3. Further, the second intermediate layer IL2 may be disposed in the third emission area EA3 and may not be disposed in the first emission area EA1 and the second emission area EA2. Furthermore, the third intermediate layer IL3 may be disposed in the second emission area EA2 and may not be disposed in the first emission area EA1 and the third emission area EA3. In this case, first to third color filters CF1, CF2, and CF3 of the optical layer OPL may be omitted.

The second electrode CAT may be disposed on the third intermediate layer IL3. The second electrode CAT may be disposed on the third intermediate layer IL3 in each of the plurality of trenches TRC. The second electrode CAT may be formed of a transparent conductive material (TCO) such as ITO or IZO that can transmit light or a semi-transmissive conductive material such as magnesium (Mg), silver (Ag), or an alloy of Mg and Ag. When the second electrode CAT is formed of a semi-transmissive conductive material, the light emission efficiency may be improved in each of the emission areas EA1, EA2, and EA3 due to a micro-cavity effect.

The encapsulation layer TFE may be disposed on the light emitting element layer EML. The encapsulation layer TFE may include at least one inorganic layer TFE1 and TFE3 to prevent oxygen or moisture from permeating into the light emitting element layer EML. In addition, the encapsulation layer TFE may include at least one organic layer TFE2 to protect the light emitting element layer EML from foreign substances such as dust. For example, the encapsulation layer TFE may include a first encapsulation inorganic layer TFE1, an encapsulation organic layer TFE2, and a second encapsulation inorganic layer TFE3.

The first encapsulation inorganic layer TFE1 may be disposed on the second electrode CAT, the encapsulation organic layer TFE2 may be disposed on the first encapsulation inorganic layer TFE1, and the second encapsulation inorganic layer TFE3 may be disposed on the encapsulation organic layer TFE2. The first encapsulation inorganic layer TFE1 and the second encapsulation inorganic layer TFE3 may be formed of multiple layers in which one or more inorganic layers of silicon nitride (SiNₓ), silicon oxynitride (SiOₓN_{y}), silicon oxide (SiOₓ), titanium oxide (TiOₓ), and aluminium oxide (AlOₓ) layers are alternately stacked. The encapsulation organic layer TFE2 may be a monomer. Alternatively, the encapsulation organic layer TFE2 may be an organic layer such as acryl resin, epoxy resin, phenolic resin, polyamide resin, polyimide resin or the like.

An adhesive layer ADL may be a layer for bonding the encapsulation layer TFE to the optical layer OPL. The adhesive layer ADL may be a double-sided adhesive member. In addition, the adhesive layer ADL may be a transparent adhesive member such as a transparent adhesive or a transparent adhesive resin.

The optical layer OPL may include a plurality of color filters CF1, CF2, and CF3, a plurality of lenses LNS, and a filling layer FIL. The plurality of color filters CF1, CF2, and CF3 may include the first to third color filters CF1, CF2, and CF3. The first to third color filters CF1, CF2, and CF3 may be disposed on the adhesive layer ADL.

The first color filter CF1 may overlap the first emission area EA1. The first color filter CF1 may transmit light of the first color, i.e., light of a blue wavelength band. The blue wavelength band may be approximately 370 nm to 460 nm. The first color filter CF1 may transmit light of the first color among light emitted from the first emission area EA1.

The second color filter CF2 may overlap the second emission area EA2. The second color filter CF2 may transmit light of the second color, i.e., light of a green wavelength band. The green wavelength band may be approximately 480 nm to 560 nm. The second color filter CF2 may transmit light of the second color among light emitted from the second emission area EA2.

The third color filter CF3 may overlap the third emission area EA3. The third color filter CF3 may transmit light of the third color, i.e., light of a red wavelength band. The blue wavelength band may be approximately 600 nm to 750 nm. The third color filter CF3 may transmit light of the third color among light emitted from the third emission area EA3.

The plurality of lenses LNS may be disposed on the first color filter CF1, the second color filter CF2, and the third color filter CF3, respectively. Each of the plurality of lenses LNS may be a structure for increasing a ratio of light directed to the front of the display device 10. Each of the plurality of lenses LNS may have a convex shape CVX in an upward direction in a cross-sectional view.

The filling layer FIL may be disposed on the plurality of lenses LNS. The filling layer FIL may have a predetermined refractive index such that light travels in the third direction DR3 at an interface between the filling layer FIL and the plurality of lenses LNS. Further, the filling layer FIL may be a planarization layer. The filling layer FIL may be an organic layer such as acrylic resin, epoxy resin, phenolic resin, polyamide resin, or polyimide resin.

The cover layer CVL may be disposed on the filling layer FIL. The cover layer CVL may be a glass substrate or a polymer resin. When the cover layer CVL is a glass substrate, it may be attached onto the filling layer FIL. In this case, the filling layer FIL may serve to bond the cover layer CVL. When the cover layer CVL is a glass substrate, it may serve as an encapsulation substrate. When the cover layer CVL is a polymer resin, it may be directly applied onto the filling layer FIL.

Although not shown in the drawing, the display part 200 may further include a polarizing plate disposed on the cover layer CVL. The polarizing plate may be disposed on one surface of the cover layer CVL. The polarizing plate may be a structure for preventing visibility degradation caused by reflection of external light. The polarizing plate may include a linear polarizing plate and a phase retardation film. For example, the phase retardation film may be a λ/4 plate (quarter-wave plate), but is not limited thereto. However, when visibility degradation caused by reflection of external light is sufficiently overcome by the first to third color filters CF1, CF2, and CF3, the polarizing plate may be omitted.

Hereinafter, a schematic method of fabricating the display device 10 will be described.

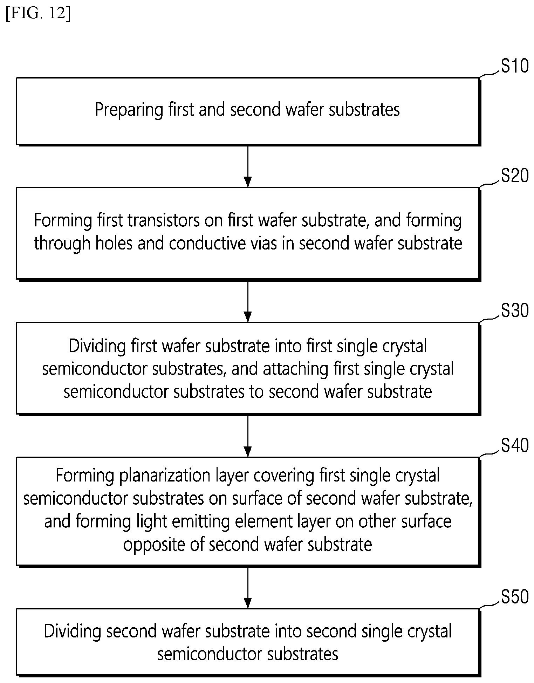

FIG. 12 is a flowchart illustrating a fabricating process of a display device according to one embodiment.

Referring to FIG. 12, a method of fabricating the display device 10 according to one embodiment may include preparing first and second wafer substrates (step S10), forming first transistors on a first wafer substrate and forming through holes and conductive vias in a second wafer substrate (step S20), dividing the first wafer substrate into first single crystal semiconductor substrates and attaching the first single crystal semiconductor substrates to the second wafer substrate (step S30), forming a planarization layer that covers the first single crystal semiconductor substrates on one surface of the second wafer substrate and forming a light emitting element layer on the other surface opposite to the one surface of the second wafer substrate (step S40), and dividing the second wafer substrate into second single crystal semiconductor substrates (step S50).

The method of fabricating the display device 10 may include performing processes suitable for forming the components of the display device 10 respectively on two different wafer substrates, and bonding them to each other. The driving part 100 including the driving circuit layer 120 may be fabricated by forming fine-sized elements on the first wafer substrate and may be bonded to the second wafer substrate, and then the display element layer 230 including the light emitting element layer EML may be formed to fabricate the display part 200. Accordingly, on the first wafer substrate, fine elements may be formed at a high integration density, thereby improving fabricating yield and reducing fabricating cost, and on the second wafer substrate, circuits other than the light emitting elements are not disposed, thereby reducing an unnecessary area and enabling the implementation of a high-resolution display device.

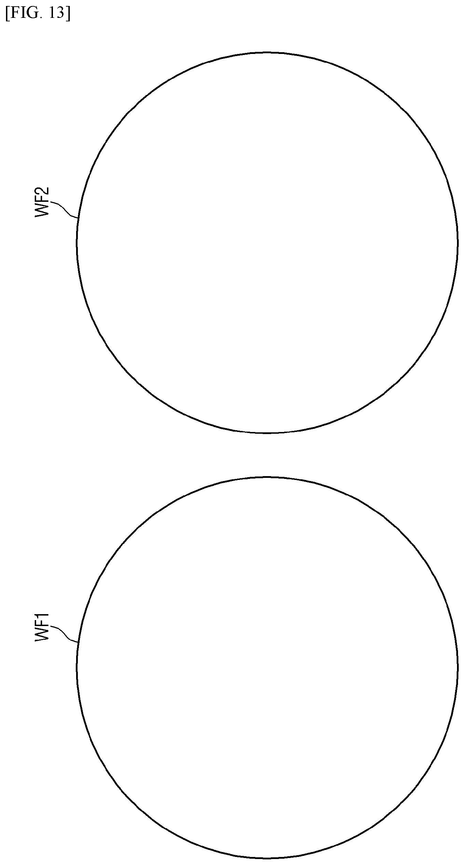

FIGS. 13 to 18 are views sequentially illustrating a fabricating process of a display device according to one embodiment.

Referring to FIG. 13, a first wafer substrate WF1 and a second wafer substrate WF2 are prepared (step S10). Each of the first wafer substrate WF1 and the second wafer substrate WF2 may be a silicon substrate, a germanium substrate, or a silicon-germanium substrate. The first single crystal semiconductor substrate 110 and the second single crystal semiconductor substrate 210 may be substrates doped with first type impurities. A plurality of well regions may be disposed on the top surface of the first single crystal semiconductor substrate 110. The first wafer substrate WF1 and the second wafer substrate WF2 may be mother substrates of the first single crystal semiconductor substrate 110 and the second single crystal semiconductor substrate 210 of the display device 10.

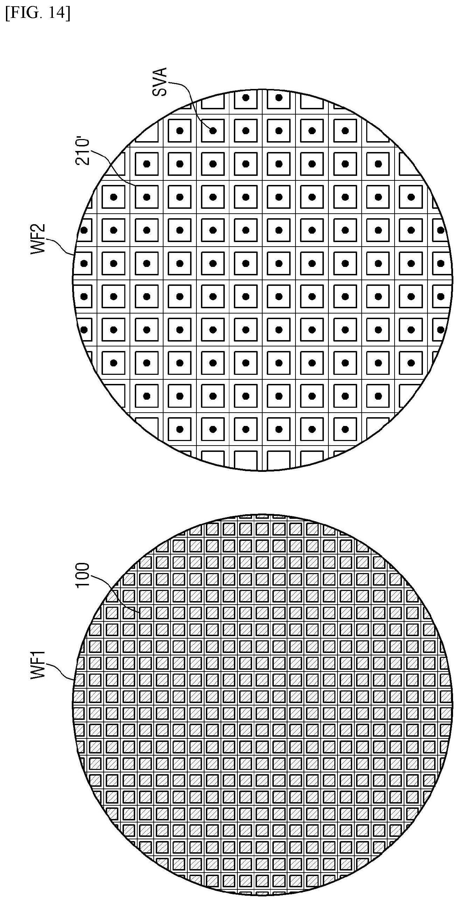

Referring to FIG. 14, the plurality of transistors PTR (e.g., the first transistors) and the driving circuit layer 120 are formed on one surface of the first wafer substrate WF1 to fabricate the driving part 100. The plurality of through holes SVA penetrating the second wafer substrate WF2 and the conductive vias RVA disposed therein are formed in the second wafer substrate WF2 to form a temporary single crystal semiconductor substrate 210'.

The process of forming the plurality of transistors PTR and the driving circuit layer 120 on the first wafer substrate WF1 may be a micro semiconductor process. On the other hand, the process of forming the through hole SVA on the second wafer substrate WF2 may be a process having a larger line width than the semiconductor process performed on the first wafer substrate WF1. Although the first wafer substrate WF1 and the second wafer substrate WF2 have the same area, the driving part 100 and the temporary single crystal semiconductor substrate 210' formed in this process may have different areas. Accordingly, the number of the driving parts 100 formed on the first wafer substrate WF1 may be greater than the number of the temporary single crystal semiconductor substrates 210' formed on the second wafer substrate WF2. The process of fabricating the driving part 100 on the first wafer substrate WF1 is an expensive semiconductor process, but has the advantage of having a relatively high yield.

In the method of fabricating the display device 10 according to one embodiment, a display device in which the pixel circuit part 800 necessary for driving the light emitting element of the display part 200 is disposed in the driving circuit layer 120 of the driving part 100 may be fabricated, and in a process of forming the driving circuit layer 120 on the first wafer substrate WF1, the driving circuit layer 120 may include the pixel circuit part 800 in addition to the driving circuit part 400, the gate driver 600, and the data driver 700.

The connection wiring layer 220 formed on the temporary single crystal semiconductor substrate 210' may be formed on the top or bottom surface of the temporary single crystal semiconductor substrate 210'.

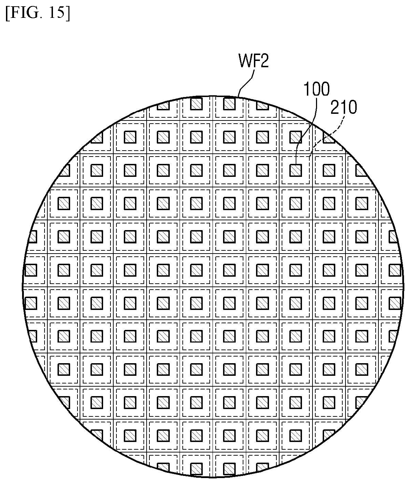

Next, referring to FIG. 15, the first wafer substrate WF1 is divided into a plurality of first single crystal semiconductor substrates 110, and the first single crystal semiconductor substrates 110 are attached to the bottom surface of the second wafer substrate WF2. The first wafer substrate WF1 may be divided into the plurality of first single crystal semiconductor substrates 110 on which the driving circuit layers 120 are formed. In some embodiments, the driving circuit layer 120 disposed on the first single crystal semiconductor substrate 110 may be bonded to the bottom surface of the temporary single crystal semiconductor substrate 210'. The process of bonding the first single crystal semiconductor substrate 110 to the bottom surface of the second wafer substrate WF2 may not be a bonding between two different wafer substrates, but rather a process of separating the first single crystal semiconductor substrate 110 from the first wafer substrate WF1 and then bonding it to the second wafer substrate WF2. The plurality of first single crystal semiconductor substrates 110 may be bonded correspondingly to the plurality of temporary single crystal semiconductor substrates 210' formed on the second wafer substrate WF2.

The process of bonding the first single crystal semiconductor substrate 110 to the second wafer substrate WF2 may be performed under a higher temperature condition than a process of forming the light emitting element layer to be described later. According to one embodiment, the process of bonding the first single crystal semiconductor substrate 110 to the second wafer substrate WF2 may be performed prior to the process of forming the light emitting element layer including the light emitting element on the second wafer substrate WF2. The method of fabricating the display device 10 may not be a method of respectively fabricating the driving part 100 including the first single crystal semiconductor substrate 110 and the display part 200 including the second single crystal semiconductor substrate 210, and bonding them to each other. The method of fabricating the display device 10 may involve a process of dividing the first wafer substrate WF1 into the driving parts 100 and bonding them to the second wafer substrate WF2 on which the light emitting elements are not formed.

In some embodiments, prior to performing the bonding process of FIG. 15, the connection wiring layer 220 may be formed on the temporary single crystal semiconductor substrate 210'. The connection wiring layer 220 may be formed on the bottom surface of the second wafer substrate WF2, and the first single crystal semiconductor substrate 110 may be attached to the bottom surface of the second wafer substrate WF2 on which the connection wiring layer 220 is formed. Accordingly, the driving circuit layer 120 formed on the first single crystal semiconductor substrate 110 may be electrically connected to the connection wiring layer 220. However, the disclosure is not limited thereto. The first single crystal semiconductor substrate 110 may be attached to the top surface of the second wafer substrate WF2 on which the connection wiring layer 220 is not formed. In this case, a planarization layer 910 to be described later may be formed on the top surface of the second wafer substrate WF2, and the light emitting element layer EML may be formed on the connection wiring layer 220 or on the bottom surface of the second wafer substrate WF2.

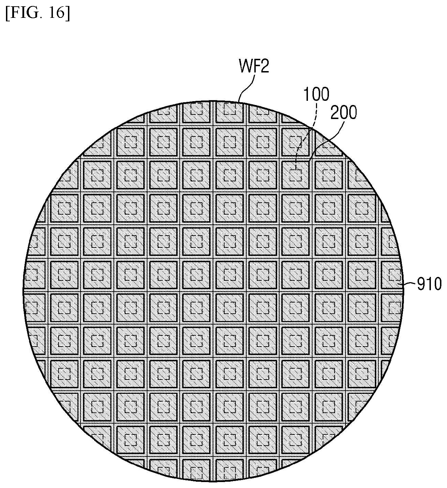

Next, referring to FIG. 16, the planarization layer 910 is formed on the bottom surface of the second wafer substrate WF2. The planarization layer 910 may planarize a stepped portion caused by the plurality of first single crystal semiconductor substrates 110 disposed on the bottom surface of the second wafer substrate WF2. As the planarization layer 910 is disposed, subsequent processes may be smoothly performed on the top surface of the second wafer substrate WF2. When the second wafer substrate WF2 is divided, the planarization layer 910 may be divided together to form the passivation layer 900 of the display device 10.

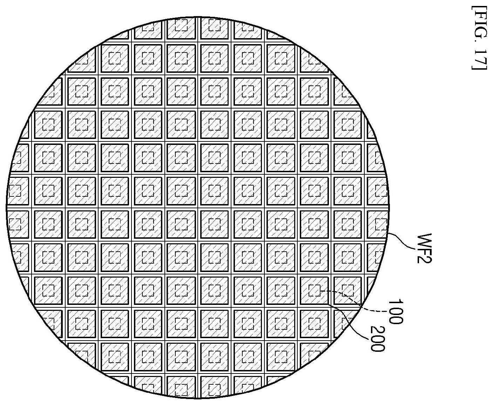

Next, referring to FIG. 17, the light emitting element layer EML is formed on the top surface of the second wafer substrate WF2 which is opposite to the bottom surface thereof where the driving part 100 is attached. The process of forming the light emitting element layer EML may be performed by a process different from the semiconductor process of forming the driving circuit layer 120 on the first wafer substrate WF1. For example, the process of forming the light emitting element layer EML may be performed by a semiconductor process having a relatively large line width, and may be a process requiring relatively low cost compared to the process of forming the driving circuit layer 120.

In the process of forming the light emitting element layer EML, the plurality of light emitting elements of the light emitting element layer EML may be respectively electrically connected to the conductive vias and the connection lines of the connection wiring layer 220, and may be electrically connected to the pixel circuit part 800 or the driving circuit layer 120 of the driving part 100 through the conductive vias and the connection lines. In addition, in this process, the display element layer 230 including the light emitting element layer EML, the reflective layer MIL, the encapsulation layer TFE, and the like may be formed. As the display element layer 230 is formed on the second wafer substrate WF2, the display part 200 including the display element layer 230 may be formed.

Next, referring to FIG. 18, the second wafer substrate WF2 may be divided into the second single crystal semiconductor substrates 210 on which the light emitting element layers EML are formed. The display element layer 230 including the light emitting element layer EML may be formed on the top surface of the divided second single crystal semiconductor substrate 210, and the connection wiring layer 220, the first single crystal semiconductor substrate 110, and the passivation layer 900 may be attached to the bottom surface thereof. Although not shown in the drawing, the display device 10 may be fabricated by attaching the circuit board 300 to one surface of the display part 200.

In the method of fabricating the display device 10 according to one embodiment, a process of forming elements of the circuit part and a process of forming the light emitting elements may be performed on different wafer substrates WF1 and WF2, respectively. In the display device 10, the elements of the circuit part and the light emitting elements may have different optimized fabricating processes, and in consideration of this, they may be formed through separate processes that can increase fabricating yield on different wafer substrates. In particular, since the process of forming the driving circuit layer 120 included in the driving part 100 of the display device 10 is performed as a micro semiconductor process, the yield per unit area of the first wafer substrate WF1 may be advantageously improved. In addition, the process of forming the display part 200 of the display device 10 has advantages in that the space occupied by unnecessary elements other than the light emitting element can be minimized and a display device with a high resolution per unit area can be implemented.

Hereinafter, various embodiments of the display device 10 will be described with reference to other drawings.

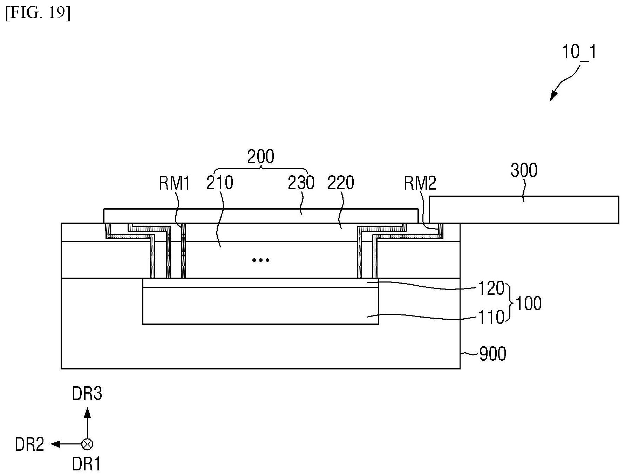

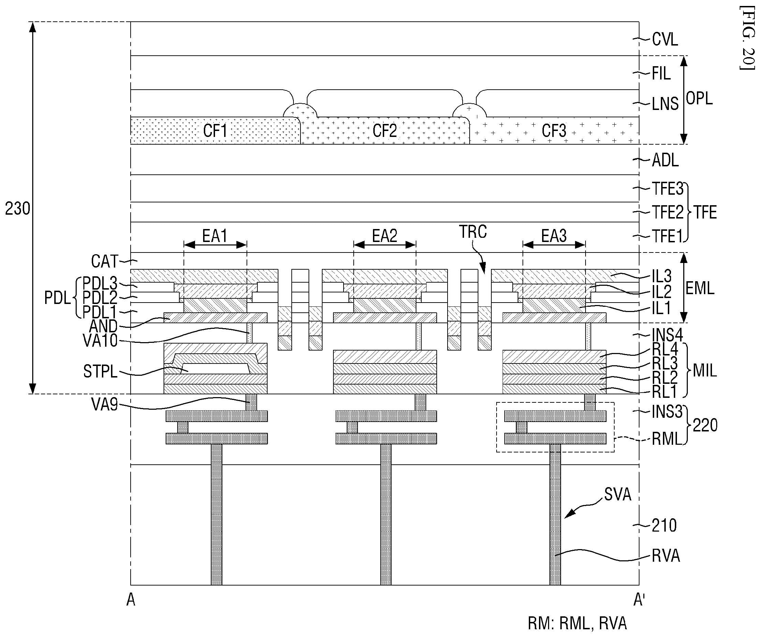

FIG. 19 is a schematic cross-sectional view of a display device according to another embodiment. FIG. 20 is a plan view illustrating an example of a display part of the display device of FIG. 19.

Referring to FIGS. 19 and 20, in a display device 10_1 according to one embodiment, the connection wiring layer 220 including the plurality of connection lines RML may be disposed between the second single crystal semiconductor substrate 210 and the light emitting element layer EML. The embodiment differs from the embodiment of FIGS. 6 and 9 in that the connection wiring layer 220 is disposed on the top surface of the second single crystal semiconductor substrate 210 rather than the bottom surface thereof, and thus the locations of the connection lines RML, the conductive vias RVA, and the through holes SVA are different.

The connection wiring layer 220 may be disposed on the top surface of the second single crystal semiconductor substrate 210. The connection wiring layer 220 may include the third interlayer insulating layer INS3, the plurality of connection lines RML, and the ninth via VA9. The third interlayer insulating layer INS3 may be disposed on the top surface of the second single crystal semiconductor substrate 210.

According to one embodiment, at least some of the plurality of through holes SVA, connection lines RML, and conductive vias RVA may overlap the display area DAA in the thickness direction. For example, at least some of the through holes SVA, connection lines RML, and conductive vias RVA may overlap the emission areas EA1, EA2, and EA3 of the light emitting element layer EML in the thickness direction. Since each of the light emitting elements disposed in the emission areas EA1, EA2, and EA3 of the light emitting element layer EML is connected to the pixel circuit part 800 through the routing lines RM1 and RM2, the connection lines RML may overlap each of the light emitting elements in the thickness direction and may be electrically connected thereto.

Since the routing line RM electrically connects the light emitting elements LE disposed on the second single crystal semiconductor substrate 210 to the pixel circuit part 800 of the first single crystal semiconductor substrate 110, the arrangement of the connection lines RML, through holes SVA, and conductive vias RVA may be variously modified depending on the relative arrangement between the light emitting element layer EML and the first single crystal semiconductor substrate 110.

For example, as the connection wiring layer 220 is disposed on the top surface of the second single crystal semiconductor substrate 210, the through holes SVA and the conductive vias RVA may be disposed to overlap the first single crystal semiconductor substrate 110. The connection lines RML may be disposed throughout the light emitting element layer EML and may be concentrated in a region where the first single crystal semiconductor substrate 110 is located. According to one embodiment, in the display device 10_1, the plurality of through holes SVA and the conductive vias RVA may each overlap the first single crystal semiconductor substrate 110 in the thickness direction. On the other hand, at least some of the connection lines RML may not overlap the first single crystal semiconductor substrate 110 in the thickness direction.

As described above, the area of the first single crystal semiconductor substrate 110 in plan view may be smaller than the area of the second single crystal semiconductor substrate 210 in plan view, and only some of the connection lines RML disposed over the entire surface of the second single crystal semiconductor substrate 210 may overlap the first single crystal semiconductor substrate 110 in the thickness direction. Accordingly, the connection lines RML may be disposed over the entire surface of the second single crystal semiconductor substrate 210, and the end of the connection line RML composed of several layers may overlap the first single crystal semiconductor substrate 110 in the thickness direction and may be connected to the plurality of through holes SVA and the conductive vias RVA. The connection lines RML may form a path electrically connecting the light emitting elements disposed in the entire display area DAA having a larger area to the pixel circuit part 800 having a relatively smaller area.

The reflective layer MIL of the display part 200 may be disposed on the connection wiring layer 220. Hereinafter, a description of each layer of the display part 200 is the same as described above.

In this embodiment, in the fabricating process of the display device 10_1, when the first single crystal semiconductor substrate 110 is attached to one surface of the second wafer substrate WF2, it may be attached to a surface thereof on which the connection wiring layer 220 is not formed. In the embodiment of FIG. 6, the first single crystal semiconductor substrate 110 may be attached to one surface of the second wafer substrate WF2 on which the connection wiring layer 220 is formed, whereas in the embodiment, the first single crystal semiconductor substrate 110 may be attached to the other surface of the second wafer substrate WF2 that is opposite to the one surface thereof on which the connection wiring layer 220 is formed. In a subsequent process, the planarization layer 910 may be formed on the other surface of the second wafer substrate WF2 to cover the first single crystal semiconductor substrate 110, and the light emitting element layer EML may be formed on the one surface of the second wafer substrate WF2 on which the connection wiring layer 220 is formed. Depending on the manner of the process of forming the connection wiring layer 220 and attaching the first single crystal semiconductor substrate 110, the relative arrangement of the connection wiring layer 220, the second single crystal semiconductor substrate 210, and the first single crystal semiconductor substrate 110 disposed in the display device 10_1 may vary.

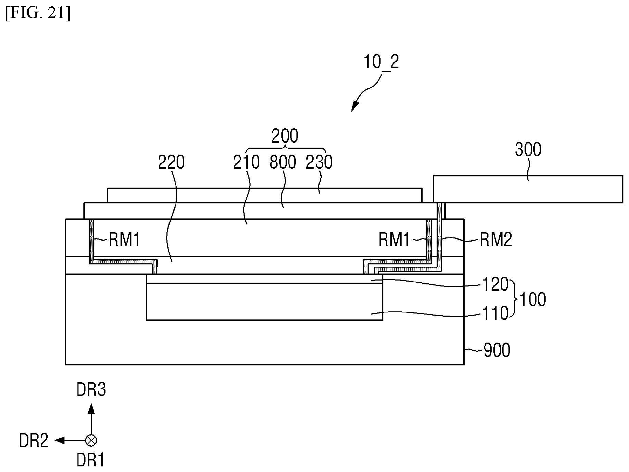

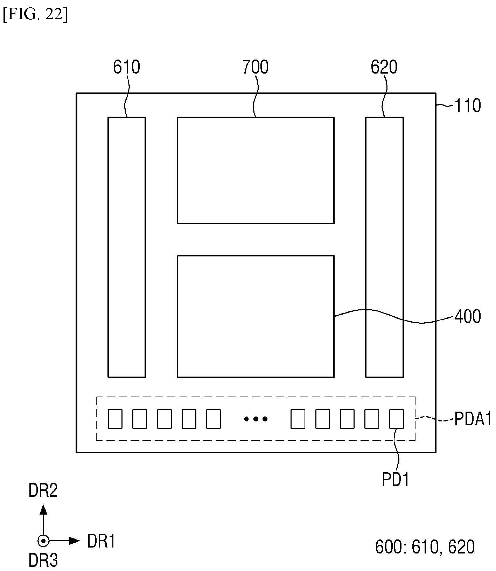

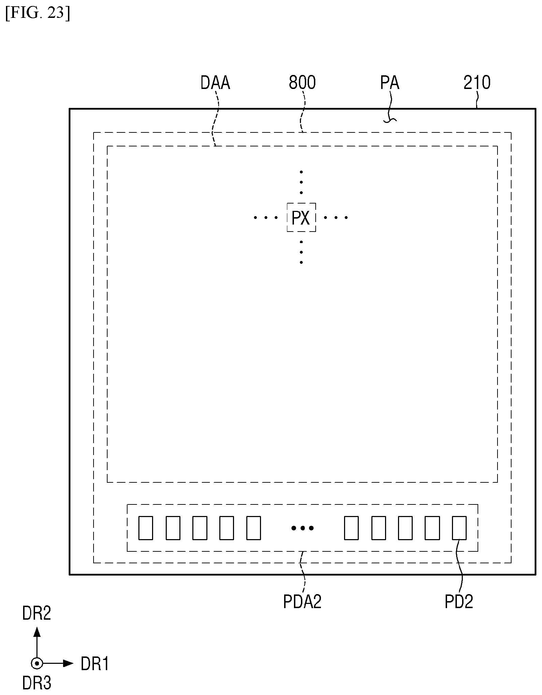

FIG. 21 is a schematic cross-sectional view of a display device according to another embodiment. FIG. 22 is a plan view illustrating an example of a driving part of the display device of FIG. 21. FIG. 23 is a plan view illustrating an example of a display part of the display device of FIG. 21.

Referring to FIGS. 21 to 23, in a display device 10_2 according to one embodiment, the pixel circuit part 800 electrically connected to the display element layer 230 may be disposed on the second single crystal semiconductor substrate 210, and the connection wiring layer 220 electrically connecting the pixel circuit part 800 to the driving circuit layer 120 of the driving part 100 may be disposed between the second single crystal semiconductor substrate 210 and the first single crystal semiconductor substrate 110. The embodiment differs from the embodiment of FIG. 6 in that the second single crystal semiconductor substrate 210 also includes a well region in the same way as the first single crystal semiconductor substrate 110, so that the pixel transistors constituting the pixel circuit part 800 are formed, and the pixel circuit part 800, which electrically connects the pixel transistors to each other, is disposed on the second single crystal semiconductor substrate 210. In the following description, redundant description will be omitted while focusing on differences.

In the driving part 100, the pixel circuit part 800 may not be formed, and other circuit parts, e.g., the driving circuit part 400, the gate driver 600, and the data driver 700 may be formed. As shown in FIG. 22, the driving part 100 may include the driving circuit part 400, the gate driver 600, the data driver 700, and the plurality of first pads PD1 formed on the first single crystal semiconductor substrate 110, and the display part 200 may include the display area DAA in which the plurality of pixels PX are disposed, the pixel circuit part 800, and the second pads PD2 disposed on the second single crystal semiconductor substrate 210.

In the display part 200, the pixel circuit part 800 and the display element layer 230 may be disposed on the second single crystal semiconductor substrate 210. The pixel circuit part 800 and the display element layer 230 may be sequentially stacked and electrically connected to each other on the second single crystal semiconductor substrate 210. Accordingly, the display device 10_2 may include the connection wiring layer 220 that connects the pixel circuit part 800 disposed on the second single crystal semiconductor substrate 210 to the driving circuit layer 120 disposed in the driving part 100.

In an embodiment, the connection wiring layer 220 may be disposed on the bottom surface of the second single crystal semiconductor substrate 210 to be positioned between the second single crystal semiconductor substrate 210 and the first single crystal semiconductor substrate 110. The connection wiring layer 220 may include the connection lines RML of the routing lines RM1 and RM2, and the conductive via RVA of the routing lines RM1 and RM2 may be disposed in the through hole penetrating the second single crystal semiconductor substrate 210.

In the display part 200, the display area DAA and the pixel circuit part 800 may be disposed to overlap each other, and the display part 200 may further include a through hole area PA, which is an area other than the display area DAA, the pixel circuit part 800, and the second pad area PDA2. The through hole area PA may be an area where terminals of the routing lines RM1 and RM2 for electrical connection between the pixel circuit part 800 and the driving circuit layer 120 of the driving part 100 are disposed. Unlike the embodiment of FIG. 6, since the light emitting elements included in the pixels PX of the display part 200 are electrically connected to the pixel circuit part 800 on the second single crystal semiconductor substrate 210, the routing lines RM1 and RM2 may electrically connect the driving circuit layer 120 of the driving part 100 to the pixel circuit part 800. Since the display device 10_2 includes the routing lines RM1 and RM2 forming the electrical connection between the pixel circuit part 800 and the driving circuit layer 120, the conductive vias RVA of the routing lines RM1 and RM2 may be disposed in the through hole area PA located outside the display area DAA.

According to one embodiment, the plurality of through holes SVA formed in the second single crystal semiconductor substrate 210 of the display part 200 may be disposed so as not to overlap the display area DAA of the second single crystal semiconductor substrate 210, and may be formed in the through hole area PA, which is an outer area of the pixel circuit part 800. Since the second single crystal semiconductor substrate 210 has a larger area than the first single crystal semiconductor substrate 110, and the display area DAA also has a larger area than the first single crystal semiconductor substrate 110, the plurality of through holes SVA of the second single crystal semiconductor substrate 210 may not overlap the first single crystal semiconductor substrate 110 in the thickness direction. Since the connection lines RML of the connection wiring layer 220 are disposed such that the routing lines RM1 and RM2 extend from the through hole area PA to an area overlapping the driving part 100, at least a part thereof may overlap the first single crystal semiconductor substrate 110 in the thickness direction.

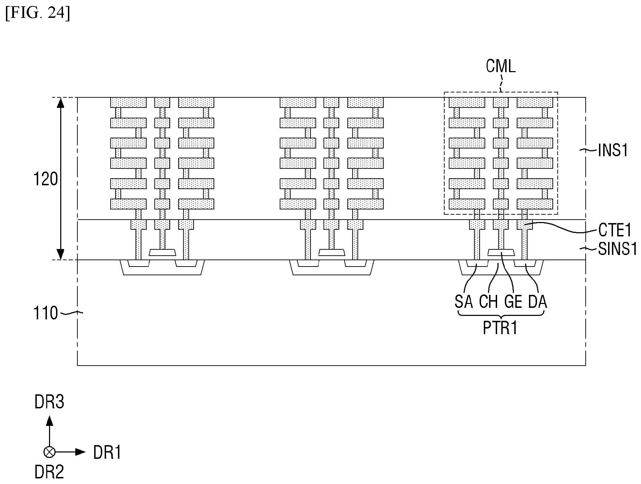

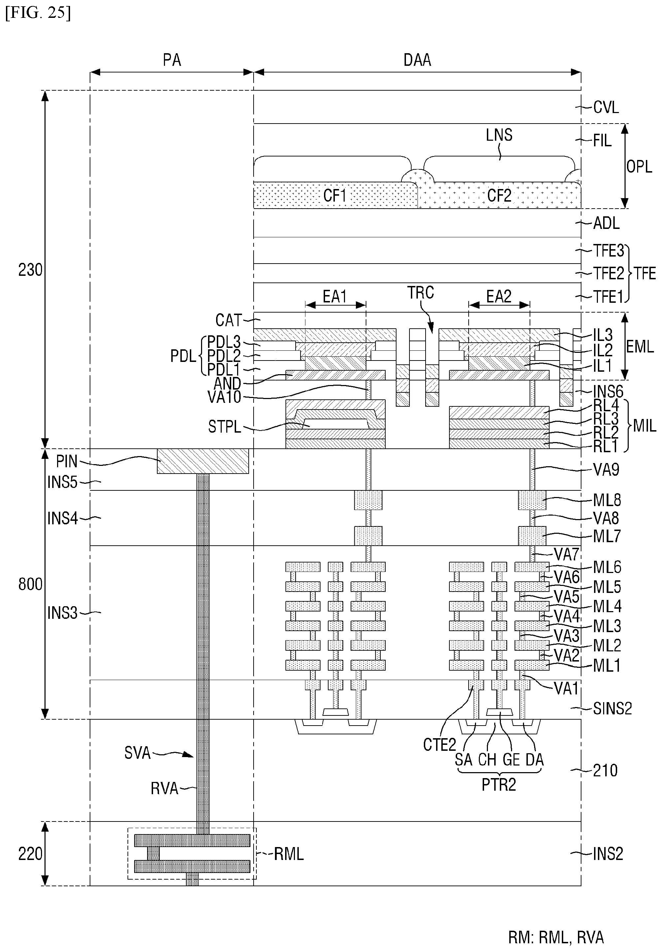

FIG. 24 is a cross-sectional view showing a part of the driving part of FIG. 22. FIG. 25 is a cross-sectional view showing a part of the display part of FIG. 23.

Referring to FIGS. 24 and 25, in the display device 10_2 according to one embodiment, the pixel circuit part 800 may not be disposed in the driving part 100, but may be disposed in the second single crystal semiconductor substrate 210. At least a part of the pixel circuit portion 800 may be included in the second single-crystal semiconductor substrate 210. For example, a part of the pixel circuit part 800 may be disposed within the second single-crystal semiconductor substrate 210, and the remaining part of the pixel circuit part 800 may be disposed on the second single-crystal semiconductor substrate 210.

As described above with reference to FIG. 9, the pixel circuit part 800 may include the plurality of conductive layers ML1 to ML8 and the plurality of vias VA1 to VA8. The pixel circuit part 800 may include wires electrically connected to a plurality of second transistors PTR2 included in the second single crystal semiconductor substrate 210. The arrangement structure and connection relationship thereof are the same as those described above, and thus redundant description will be omitted.

The driving part 100 may include a plurality of first transistors PTR1 formed on the first single crystal semiconductor substrate 110. At least a part of each of the plurality of first transistors PTR1 may be included in the first single-crystal semiconductor substrate 110. For example, a part of each of the plurality of first transistors PTR1 may be disposed within the first single-crystal semiconductor substrate 110, and the remaining part of each of the plurality of first transistors PTR1 may be partially disposed on the first single-crystal semiconductor substrate 110. For example, the source region SA, the channel region CH, and the drain region DA of the first transistor PTR1 may be disposed within the first single-crystal semiconductor substrate 110, and the gate electrode GE of the first transistor PTR1 may be disposed on the first single-crystal semiconductor substrate 110.

The first transistors PTR1 may be CMOS transistors formed on the first wafer substrate through a semiconductor process. The plurality of first transistors PTR1 may be transistors constituting the driving circuit part 400, the gate driver 600, and the data driver 700 disposed in the driving part 100. The driving circuit layer 120 including a plurality of first contact electrodes CTE1, a first semiconductor insulating layer SINS1, a first interlayer insulating layer INS1, and a plurality of circuit conductive layers CML may be disposed on the first single crystal semiconductor substrate 110. The driving circuit layer 120 may include wires electrically connected to the plurality of first transistors PTR1 included in the first single crystal semiconductor substrate 110. The driving circuit part 400, the gate driver 600, and the data driver 700 of the driving part 100 may be formed through the plurality of first transistors PTR1, and the first contact electrodes CTE1 and the circuit conductive layers CML of the driving circuit layer 120.

The display part 200 may include the plurality of second transistors PTR2 formed on the second single crystal semiconductor substrate 210. At least a part of each of the plurality of second transistors PTR2 may be included in the second single-crystal semiconductor substrate 210. For example, a part of each of the plurality of second transistors PTR2 may be disposed within the second single-crystal semiconductor substrate 210, and the remaining part of each of the plurality of second transistors PTR2 may be disposed on the single-crystal semiconductor substrate 210. For example, a source region SA, a channel region CH, and a drain region DA of the second transistor PTR2 may be disposed within the second single-crystal semiconductor substrate 210, and a gate electrode GE of the second transistor PTR2 may be disposed on the second single-crystal semiconductor substrate 210.

The plurality of second transistors PTR2 may be transistors constituting the pixel circuit part 800 disposed in the display part 200. A plurality of second contact electrodes CTE2, a second semiconductor insulating layer SINS2, third to fifth interlayer insulating layers INS3, INS4, and INS5, and the plurality of conductive layers ML1 to ML8 may be disposed on the second single crystal semiconductor substrate 210. The pixel circuit part 800 of the display part 200 may be formed through the plurality of second transistors PTR2, the second contact electrodes CTE2, and the plurality of conductive layers ML1 to ML8. The pixel circuit part 800 may include wires electrically connected to the plurality of second transistors PTR2 included in the second single crystal semiconductor substrate 210.

The connection wiring layer 220 may be disposed on the bottom surface of the second single crystal semiconductor substrate 210. The connection wiring layer 220 may include a second interlayer insulating layer INS2, the plurality of connection lines RML, and a part of the conductive via RVA. The description of the second interlayer insulating layer INS2 and the connection line RML is the same as described above.

According to one embodiment, the display device 10_2 may include the plurality of through holes SVA penetrating the second single crystal semiconductor substrate 210 in the through hole area PA of the display part 200. The through hole SVA may be formed to penetrate the second single crystal semiconductor substrate 210, and the third to fifth interlayer insulating layers INS3, INS4, and INS5 disposed thereabove. The display part 200 may include a connection pad PIN disposed in the through hole area PA and electrically connected to elements and wires of the pixel circuit part 800. The through hole SVA may be formed to extend from the connection line RML of the connection wiring layer 220 to the connection pad PIN, and the conductive via RVA of the routing lines RM1 and RM2 may be disposed in the through hole SVA. The connection pad PIN disposed in the display part 200 may be electrically connected to the connection line RML through the conductive via RVA. Output pins of the circuit parts may be formed in the driving circuit layer 120, and the conductive vias RVA may be bonded to the output pins to be electrically connected thereto. The pixel circuit part 800 may be electrically connected to the driving circuit layer 120 of the driving part 100 through the routing line RM and the connection pad PIN formed in the through hole area PA.

Meanwhile, the display device 10_2 may include the first transistor PTR1 included in the first single crystal semiconductor substrate 110 of the driving part 100, and the second transistor PTR2 included in the second single crystal semiconductor substrate 210 of the display part 200. At least a part of the first transistor PTR1 may be disposed within the first single-crystal semiconductor substrate 110, and the remaining part of the first transistor PTR1 may be disposed on the first single-crystal semiconductor substrate 110. At least a part of the second transistor PTR2 may be disposed within a second single-crystal semiconductor substrate 210, and the remaining part of the second transistor PTR2 may be disposed on the second single-crystal semiconductor substrate 210.

The first transistor PTR1 and the second transistor PTR2 may be disposed on different single crystal semiconductor substrates 110 and 210, and the wafer substrates on which the transistors PTR1 and PTR2 are formed in the fabricating process of the display device 10_2 may also be different. According to one embodiment, in the display device 10_2, the first transistor PTR1 formed on the first single crystal semiconductor substrate 110 and the second transistor PTR2 formed on the second single crystal semiconductor substrate 210 may have different sizes, line widths, and the like.

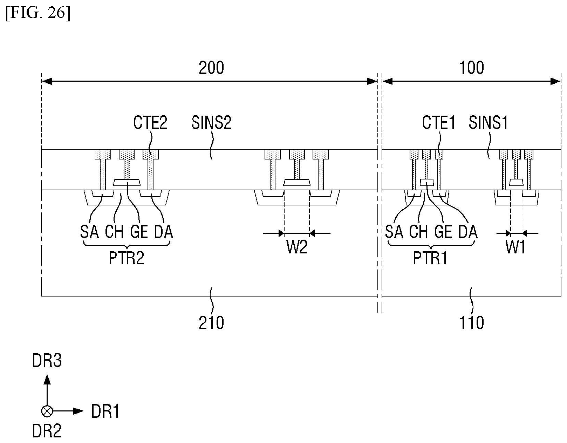

FIG. 26 is a cross-sectional view schematically illustrating transistors of a driving part and a display part of the display device of FIG. 21.

Referring to FIG. 23, in the display device 10_2, the minimum line width of the first transistor PTR1 included in the first single crystal semiconductor substrate 110 may be smaller than the minimum line width of the second transistor PTR2 included in the second single crystal semiconductor substrate 210. The semiconductor process performed on the first wafer substrate for the formation of the first transistor PTR1 is a process having higher resolution than the semiconductor process performed on the second wafer substrate for the formation of the second transistor PTR2, and thus the size of an element such as a fabricated transistor may be smaller. In other words, the semiconductor process performed on the first wafer substrate may be a finer process than the semiconductor process performed on the second wafer substrate.

As described above, the first single crystal semiconductor substrate 110 of the driving part 100 may have a smaller area in plan view than the second single crystal semiconductor substrate 210 of the display part 200, and small-sized elements may be arranged with a high integration density to reduce power consumption and improve fabricating yield. On the other hand, the second single crystal semiconductor substrate 210 of the display part 200 may have a larger area in plan view than the first single crystal semiconductor substrate 110, and the fabricating process for forming the light emitting element may require lower resolution than a process for forming a fine element such as the first transistor PTR1. The pixel circuit part 800 disposed on the second single crystal semiconductor substrate 210 may also have a larger area than when formed on the first single crystal semiconductor substrate 110, and the second transistors PTR2 constituting the pixel circuit part 800 may not require a high integration density. Accordingly, the semiconductor process performed on the first wafer substrate may be performed as a high-cost process having a small line width, and the semiconductor process performed on the second wafer substrate may be performed as a low-cost process having a relatively large line width.

In the display device 10_2, the plurality of transistors PTR1 and PTR2 included in the first single crystal semiconductor substrate 110 and the second single crystal semiconductor substrate 210 may have different minimum line widths. In an embodiment, the lengths of the channel regions CH of the plurality of transistors PTR1 and PTR2 may be different from each other, and the minimum line width or a length W1 of the channel region CH of the first transistor PTR1 may be smaller than the minimum line width or a length W2 of the channel region CH of the second transistor PTR2. The minimum line width or the length W1 of the channel region CH of the first transistor PTR1 may be equal to or less than 100 nm, or may range from 2 nm to 80 nm. The minimum line width or the length W2 of the channel region CH of the second transistor PTR2 may be greater than or equal to 100 nm, or may range from 100 nm to 5 µm.

In the drawing, the minimum line widths of the transistors PTR1 and PTR2 are compared with each other through the lengths W1 and W2 of the channel regions CH, but the disclosure is not limited thereto. The minimum line widths of the transistors PTR1 and PTR2 may not be compared through the lengths W1 and W2 of the channel regions CH, but may be compared through other configurations. For example, the minimum line widths of the transistors PTR1 and PTR2 may be compared with each other through the wiring widths of the gate electrodes GE of the transistors PTR1 and PTR2. Alternatively, the minimum line widths of the transistors PTR1 and PTR2 may be the minimum line widths of the wires of the gate electrodes GE of the transistors PTR1 and PTR2. In addition, although the drawing shows the lengths W1 and W2 of the channel regions CH as the distances between the source regions SA and the drain regions DA formed on the single crystal semiconductor substrates 110 and 210, the disclosure is not limited thereto.

In the display device 10_2, the circuit parts provided in the driving part 100 may be formed by a high-cost micro semiconductor process, and thus may be formed with a high integration density on the first single crystal semiconductor substrate 110 having a small area. The fabricating process of the driving part 100 may have a high yield per unit wafer substrate, and a circuit element (e.g., the first transistor) may have a small size, resulting in reduced power consumption. In the display device 10_2, the circuit elements of the pixel circuit part 800 and the display element layer 230 formed in the display part 200 may be formed by a relatively low-cost semiconductor process, thereby reducing fabricating cost. Nevertheless, since some of the circuit parts for light emission of the light emitting elements of the display device 10_2 are disposed in the driving part 100, there is still the advantage that a high-resolution display device can be implemented.

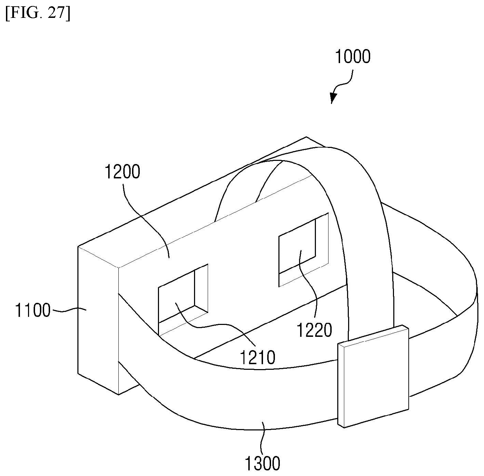

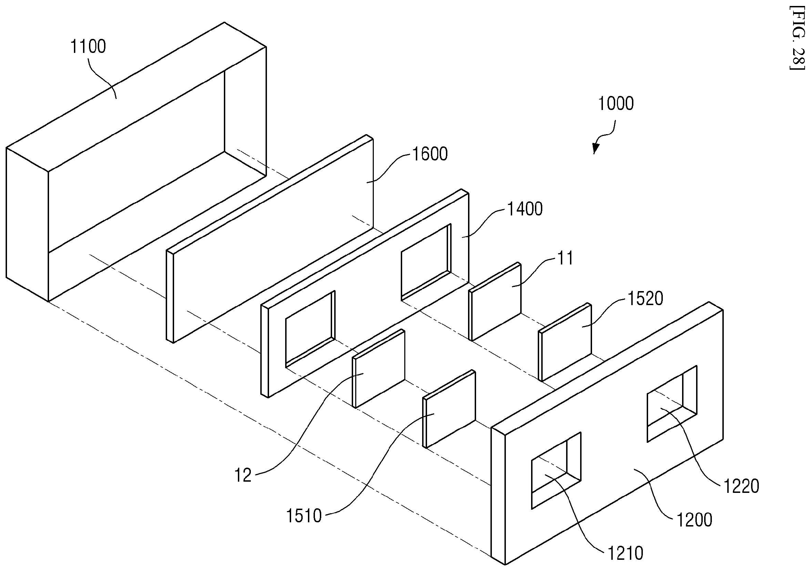

FIG. 27 is a perspective view illustrating a head mounted display device according to one embodiment. FIG. 28 is an exploded perspective view showing an example of the head mounted display device of FIG. 27.

Referring to FIGS. 27 and 28, a head mounted display device 1000 according to one embodiment includes a first display device 11, a second display device 12, a display device storage 1100, a storage cover 1200, a first eyepiece 1210, a second eyepiece 1220, a head mounted band 1300, a middle frame 1400, a first optical member 1510, a second optical member 1520, a control circuit board 1600, and a connector.

The first display device 11 provides an image to a user's left eye, and the second display device 12 provides an image to a user's right eye. Since each of the first display device 11 and the second display device 12 is substantially the same as the display devices 10, 10_1, and 10_2 described in conjunction with FIG. 1, the description of the first display device 11 and the second display device 12 will be omitted.

The first optical member 1510 may be disposed between the first display device 11 and the first eyepiece 1210. The second optical member 1520 may be disposed between the second display device 12 and the second eyepiece 1220. Each of the first optical member 1510 and the second optical member 1520 may include at least one convex lens.

The middle frame 1400 may be disposed between the first display device 11 and the control circuit board 1600 and between the second display device 12 and the control circuit board 1600. The middle frame 1400 serves to support and fix the first display device 11, the second display device 12, and the control circuit board 1600.

The control circuit board 1600 may be disposed between the middle frame 1400 and the display device storage 1100. The control circuit board 1600 may be connected to the first display device 11 and the second display device 12 through the connector. The control circuit board 1600 may convert an image source inputted from the outside into the digital video data DATA, and may transmit the digital video data DATA to the first display device 11 and the second display device 12 through the connector.

The control circuit board 1600 may transmit the digital video data DATA corresponding to a left-eye image optimized for the user's left eye to the first display device 11, and may transmit the digital video data DATA corresponding to a right-eye image optimized for the user's right eye to the second display device 12. Alternatively, the control circuit board 1600 may transmit the same digital video data DATA to the first display device 11 and the second display device 12.

The display device storage 1100 serves to accommodate the first display device 11, the second display device 12, the middle frame 1400, the first optical member 1510, the second optical member 1520, the control circuit board 1600, and the connector. The storage cover 1200 is disposed to cover one open surface of the display device storage 1100. The storage cover 1200 may include the first eyepiece 1210 at which the user's left eye is disposed and the second eyepiece 1220 at which the user's right eye is disposed. FIGS. 24 and 25 illustrate that the first eyepiece 1210 and the second eyepiece 1220 are disposed separately, but the disclosure is not limited thereto. The first eyepiece 1210 and the second eyepiece 1220 may be combined into one.

The first eyepiece 1210 may be aligned with the first display device 11 and the first optical member 1510, and the second eyepiece 1220 may be aligned with the second display device 12 and the second optical member 1520. Accordingly, the user may view the image of the first display device 11 magnified as a virtual image by the first optical member 1510 through the first eyepiece 1210, and may view the image of the second display device 12 magnified as a virtual image by the second optical member 1520 through the second eyepiece 1220.

The head mounted band 1300 serves to secure the display device storage 1100 to the user's head such that the first eyepiece 1210 and the second eyepiece 1220 of the storage cover 1200 remain disposed on the user's left and right eyes, respectively. When the display device storage 1200 is implemented to be lightweight and compact, the head mounted display device 1000 may be provided with, as shown in FIG. 26, an eyeglass frame instead of the head mounted band 1300.

In addition, the head mounted display device 1000 may further include a battery for supplying power, an external memory slot for accommodating an external memory, and an external connection port and wireless communication module for receiving an image source. The external connection port may be a universe serial bus (USB) terminal, a display port, or a high-definition multimedia interface (HDMI) terminal, and the wireless communication module may be a 5G communication module, a 4G communication module, a Wi-Fi module, or a Bluetooth module.

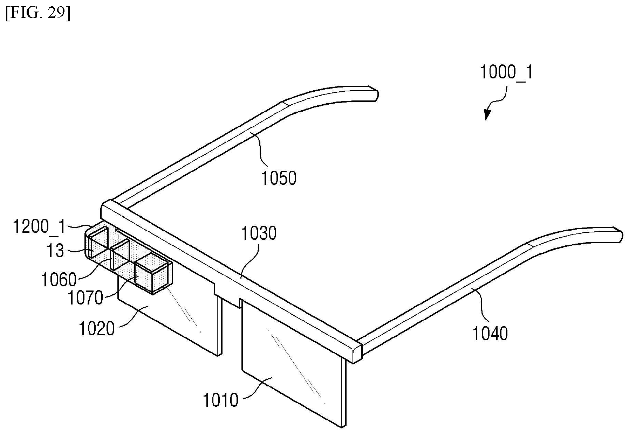

FIG. 29 is a perspective view illustrating a head mounted display device according to one embodiment.

Referring to FIG. 29, a head mounted display device 1000_1 according to one embodiment may be an eyeglasses-type display device in which a display device storage 1200_1 is implemented in a lightweight and compact manner. The head mounted display device 1000_1 according to one embodiment may include a display device 13, a left eye lens 1010, a right eye lens 1020, a support frame 1030, temples 1040 and 1050, an optical member 1060, an optical path conversion member 1070, and the display device storage 1200_1.

The display device storage 1200_1 may include the display device 13, the optical member 1060, and the optical path conversion member 1070. An image displayed on the display device 13 may be magnified by the optical member 1060, and the optical path may be converted by the optical path conversion member 1070 to provide the image to the user's right eye through the right eye lens 1020. As a result, the user may view an augmented reality image, through the right eye, in which a virtual image displayed on the display device 13 and a real image seen through the right eye lens 1020 are combined.

FIG. 29 illustrates that the display device storage 1200_1 is disposed on the right end of the support frame 1030, but the disclosure is not limited thereto. For example, the display device storage 1200_1 may be disposed on the left end of the support frame 1030, and in this case, the image of the display device 13 may be provided to the user's left eye. Alternatively, the display device storage 1200_1 may be disposed on both the left and right ends of the support frame 1030, and in this case, the user may view the image displayed on the display device 13 through both the left and right eyes.

Although embodiments of the present invention have been described with reference to the attached drawings, those skilled in the art will appreciate that the present invention can be implemented in other specific forms without altering the technical idea or essential characteristics of the present invention. Therefore, the embodiments described above should be understood to be illustrative in all respects and not restrictive.

## Claims

1. A display device comprising:
a first single crystal semiconductor substrate comprising a plurality of first transistors;
a second single crystal semiconductor substrate disposed on the first single crystal semiconductor substrate and comprising a plurality of second transistors;
a light emitting element layer disposed on the second single crystal semiconductor substrate and comprising a plurality of light emitting elements,
wherein in plan view, an area of the first single crystal semiconductor substrate is smaller than an area of the second single crystal semiconductor substrate, and
a minimum line width of one of the plurality of first transistors is smaller than a minimum line of one of the plurality of second transistors.

2. The display device of claim 1, wherein the minimum line width of one of the plurality of first transistors is less than 100 nm, and
the minimum line width of one of the plurality of second transistors is equal to or greater than 100 nm.

3. The display device of claim 1, wherein the second single crystal semiconductor substrate comprises a plurality of through holes spaced apart from each other and a plurality of conductive vias respectively disposed in the plurality of through holes.

4. The display device of claim 3, further comprising a connection wiring layer comprising a plurality of connection lines disposed between the first single crystal semiconductor substrate and the light emitting element layer and electrically connected to the plurality of conductive vias, respectively.

5. The display device of claim 4, wherein the connection wiring layer is disposed between the first single crystal semiconductor substrate and the second single crystal semiconductor substrate.

6. The display device of claim 4, wherein the plurality of through holes do not overlap the first single crystal semiconductor substrate in a thickness direction.

7. The display device of claim 4, wherein some of the plurality of connection lines overlap the first single crystal semiconductor substrate in a thickness direction.

8. The display device of claim 1, wherein each of the first single crystal semiconductor substrate and the second single crystal semiconductor substrate is a silicon substrate or a silicon-germanium substrate, and has a thickness of 100 µm or less.

9. The display device of claim 1, wherein the light emitting element layer comprises a plurality of reflective layers disposed between the second single crystal semiconductor substrate and the light emitting element, and an interlayer insulating layer disposed between the reflective layer and the light emitting element, and
the plurality of reflective layers is disposed to correspond to the plurality of light emitting elements, respectively.

10. The display device of claim 9, wherein the light emitting elements comprise a first light emitting element disposed in a first emission area emitting light of a first color, and a second light emitting element disposed in a second emission area emitting light of a second color different from the first color, and
a thickness of the interlayer insulating layer disposed between the first light emitting element and the reflective layer overlapping the first light emitting element is different from a thickness of the interlayer insulating layer disposed between the second light emitting element and the reflective layer overlapping the second light emitting element.

11. A display device comprising:
a first single crystal semiconductor substrate comprising a plurality of first transistors;
a second single crystal semiconductor substrate disposed on the first single crystal semiconductor substrate, and comprising a plurality of through holes spaced apart from each other and a plurality of conductive vias respectively disposed in the plurality of through holes;
a light emitting element layer disposed on the second single crystal semiconductor substrate and comprising a plurality of light emitting elements; and
a connection wiring layer comprising connection lines electrically connected to the plurality of conductive vias, respectively,
wherein in plan view, an area of the first single crystal semiconductor substrate is smaller than an area of the second single crystal semiconductor substrate.

12. The display device of claim 11, wherein the second single crystal semiconductor substrate comprises a plurality of second transistors electrically connected to the plurality of light emitting elements, respectively, and
the connection wiring layer is disposed between the first single crystal semiconductor substrate and the second single crystal semiconductor substrate.

13. The display device of claim 12, wherein the plurality of through holes do not overlap the first single crystal semiconductor substrate in a thickness direction.

14. The display device of claim 12, wherein some of the plurality of connection lines overlap the first single crystal semiconductor substrate in a thickness direction.

15. The display device of claim 11, wherein the first single crystal semiconductor substrate further comprises a plurality of second transistors electrically connected to the plurality of light emitting elements, respectively, and
the connection wiring layer is disposed between the first single crystal semiconductor substrate and the light emitting element layer.

16. The display device of claim 15, wherein the connection wiring layer is disposed between the first single crystal semiconductor substrate and the second single crystal semiconductor substrate.

17. The display device of claim 16, wherein at least some of the plurality of through holes do not overlap the first single crystal semiconductor substrate in a thickness direction.

18. The display device of claim 16, wherein at least some of the plurality of connection lines do not overlap the first single crystal semiconductor substrate in a thickness direction.

19. The display device of claim 15, wherein the connection wiring layer is disposed between the second single crystal semiconductor substrate and the light emitting element layer.

20. The display device of claim 19, wherein the plurality of through holes overlap the first single crystal semiconductor substrate in a thickness direction.

21. A display device comprising:
a first single crystal semiconductor substrate comprising a plurality of first transistors;
a second single crystal semiconductor substrate disposed on the first single crystal semiconductor substrate;
a light emitting element layer disposed on the second single crystal semiconductor substrate and comprising a plurality of light emitting elements; and
a passivation layer surrounding the first single crystal semiconductor substrate and in partial contact with the second single crystal semiconductor substrate,
wherein in plan view, an area of the first single crystal semiconductor substrate is smaller than an area of the second single crystal semiconductor substrate.

22. The display device of claim 21, wherein a side surface of the passivation layer is parallel to a side surface of the second single crystal semiconductor substrate.

23. The display device of claim 21, wherein a thickness of the passivation layer is greater than or equal to a thickness of the first single crystal semiconductor substrate.

24. The display device of claim 21, wherein the passivation layer is in contact with each of a bottom surface of the first single crystal semiconductor substrate and a bottom surface of the second single crystal semiconductor substrate.

25. The display device of claim 21, wherein the second single crystal semiconductor substrate comprises a plurality of through holes spaced apart from each other, and a plurality of conductive vias respectively disposed in the plurality of through holes,
the display device further comprising a connection wiring layer disposed between the first single crystal semiconductor substrate and the light emitting element layer and comprising a plurality of connection lines electrically connected to the plurality of conductive vias, respectively.

26. The display device of claim 25, wherein the first single crystal semiconductor substrate further comprises a plurality of second transistors electrically connected to the light emitting elements, respectively, and
at least some of the plurality of connection lines do not overlap the first single crystal semiconductor substrate in a thickness direction.

27. The display device of claim 26, wherein each of the plurality of light emitting elements is electrically connected to one of the plurality of second transistors through the connection lines and the conductive vias.

28. The display device of claim 25, wherein the second single crystal semiconductor substrate comprises a plurality of second transistors electrically connected to the light emitting elements, respectively, and
a minimum line width of one of the plurality of first transistors is smaller than a minimum line width of one of the plurality of second transistors.

29. A method of fabricating a display device, comprising:
preparing a first wafer substrate and a second wafer substrate different from each other;
forming a plurality of first transistors on the first wafer substrate, and forming, in the second wafer substrate, a plurality of through holes penetrating the second wafer substrate and a plurality of conductive vias respectively disposed in the plurality of through holes;
dividing the first wafer substrate into a plurality of first single crystal semiconductor substrates, and attaching the first single crystal semiconductor substrates to one surface of the second wafer substrate;
forming a planarization layer covering the one surface of the second wafer substrate and the first single crystal semiconductor substrates attached to the one surface;
forming a light emitting element layer comprising a plurality of light emitting elements on the other surface opposite to the one surface of the second wafer substrate; and
dividing the second wafer substrate into a plurality of second single crystal semiconductor substrates having the light emitting element layer formed on the other surface and the first single crystal semiconductor substrates attached to the one surface.

30. The method of claim 29, wherein in plan view, an area of the first single crystal semiconductor substrate is smaller than an area of the second single crystal semiconductor substrate.

31. The method of claim 29, wherein in the forming of the planarization layer, in plan view, an area of the planarization layer is equal to an area of the second wafer substrate.

32. The method of claim 29, wherein in the dividing of the second wafer substrate into the plurality of second single crystal semiconductor substrates, the planarization layer is divided together with the second single crystal semiconductor substrate to form a passivation layer surrounding the first single crystal semiconductor substrate, and
in the display device, a side surface of the passivation layer is parallel to a side surface of the second single crystal semiconductor substrate.

33. The method of claim 29, further comprising, before forming the through holes in the second wafer substrate, forming a plurality of second transistors,
wherein a minimum line width of one of the plurality of first transistors is smaller than a minimum line width of one of the plurality of second transistors.

34. The method of claim 33, wherein the minimum line width of one of the plurality of first transistors is less than 100 nm, and
the minimum line width of one of the plurality of second transistors is equal to or greater than 100 nm.

35. The method of claim 29, further comprising, before attaching the first single crystal semiconductor substrate to the second wafer substrate, forming a connection wiring layer comprising connection lines electrically connected to the plurality of conductive vias, respectively.

36. The method of claim 35, wherein the connection wiring layer is formed on the one surface of the second single crystal semiconductor substrate, and disposed between the second single crystal semiconductor substrate and the first single crystal semiconductor substrate.

37. The method of claim 35, wherein the connection wiring layer is formed on the other surface of the second single crystal semiconductor substrate, and disposed between the second single crystal semiconductor substrate and the light emitting element layer.

38. The method of claim 29, wherein each of the first single crystal semiconductor substrate and the second single crystal semiconductor substrate is a silicon substrate or a silicon-germanium substrate, and has a thickness of 100 µm or less.

39. A head mounted display device comprising:
a plurality of display devices; and
an optical member configured to magnify a display image of the plurality of display devices or convert an optical path of the display image of the plurality of display devices,
wherein the display device comprises:
a first single crystal semiconductor substrate comprising a plurality of first transistors;
a second single crystal semiconductor substrate disposed on the first single crystal semiconductor substrate, and comprising a plurality of through holes spaced apart from each other and a plurality of conductive vias respectively disposed in the plurality of through holes; and
a light emitting element layer disposed on the second single crystal semiconductor substrate and comprising a plurality of light emitting elements,
wherein in plan view, an area of the first single crystal semiconductor substrate is smaller than an area of the second single crystal semiconductor substrate.

40. The head mounted display device of claim 39, wherein the display device further comprises a passivation layer surrounding the first single crystal semiconductor substrate and in partial contact with the second single crystal semiconductor substrate.

41. The head mounted display device of claim 39, wherein the display device further comprises a connection wiring layer comprising a plurality of connection lines electrically connected to the plurality of conductive vias, respectively.

42. The head mounted display device of claim 41, wherein the second single crystal semiconductor substrate of the display device comprises a plurality of second transistors electrically connected to the plurality of light emitting elements, respectively, and
the connection wiring layer is disposed between the first single crystal semiconductor substrate and the second single crystal semiconductor substrate.

43. The head mounted display device of claim 42, wherein in the display device, a minimum line width of one of the plurality of first transistors is smaller than a minimum line width of one of the plurality of second transistors.

44. The head mounted display device of claim 43, wherein the minimum line width of one of the plurality of first transistors is less than 100 nm, and
the minimum line width of one of the plurality of second transistors is equal to or greater than 100 nm.

45. The head mounted display device of claim 41, wherein the first single crystal semiconductor substrate of the display device comprises a plurality of second transistors electrically connected to the plurality of light emitting elements, respectively, and
the connection wiring layer is disposed between the first single crystal semiconductor substrate and the light emitting element layer.

46. The head mounted display device of claim 45, wherein the connection wiring layer is disposed between the first single crystal semiconductor substrate and the second single crystal semiconductor substrate, and
at least some of the plurality of through holes do not overlap the first single crystal semiconductor substrate in a thickness direction.

47. The head mounted display device of claim 45, wherein the connection wiring layer is disposed between the second single crystal semiconductor substrate and the light emitting element layer, and
the plurality of through holes overlap the first single crystal semiconductor substrate in a thickness direction.

48. The head mounted display device of claim 39, wherein in the display device, each of the first single crystal semiconductor substrate and the second single crystal semiconductor substrate is a silicon substrate or a silicon-germanium substrate, and has a thickness of 100 µm or less.
